# EUROPÄISCHE PATENTSCHRIFT

(11) **EP 3 607 624 B1**
(45) Veröffentlichungstag und Bekanntmachung des Hinweises auf die Patenterteilung: **27.01.2021**
(21) Anmeldenummer: 18721948.0
(22) Anmeldetag: 19.04.2018
(51) Int. Cl.: H02B 1/30, H02B 1/32

(54) **ANORDNUNG AUS EINEM SCHALTSCHRANKSOCKEL UND EINEM DARAUF MONTIERTEN SCHALTSCHRANKRAHMENGESTELL SOWIE EINE ENTSPRECHENDE SCHALTSCHRANKREIHE**
ARRANGEMENT OF A BASE AND AN ELECTRICAL CABINET FRAME MOUNTED THEREON AND CORRESPONDING ALIGNEMENT OF ELECTRICAL CABINETS
ENSEMBLE COMPRENANT UN SOCLE ET UN CHÂSSIS POUR ARMOIRE ÉLECTRIQUE AINSI QU'UNE RANGÉE D'ARMOIRES ÉLECTRIQUES

(30) Priorität: 28.06.2017 DE 102017114389
(43) Veröffentlichungstag der Anmeldung: 12.02.2020
(73) Patentinhaber: Rittal GmbH & Co. KG, 35745 Herborn (DE)
(72) Erfinder: KLANER, Thomas, 35274 Kirchhain (DE); BYRNE, Glenn, 45414-5427 Dayton Ohio (US); TOM, Jason, 43044 Mechanicsburg Ohio (US)
(74) Vertreter: Angerhausen, Christoph
(86) Internationale Anmeldenummer: PCT/DE2018/100375
(87) Internationale Veröffentlichungsnummer: WO 2019/001610

(56) Entgegenhaltungen:
- EP-A2- 0 158 216
- DE-A1-102011 013 158
- DE-A1-102015 121 193

## Beschreibung

Die Erfindung geht aus von einer Anordnung aus einen Schaltschranksockel und einem darauf montierten Schaltschrankrahmengestell, wobei der Schaltschranksockel mehrere Sockeleckstücke aufweist, die an dem Schaltschrankrahmengestell festgelegt sind, und das Schaltschrankrahmengestell eine Mehrzahl Profilstreben aufweist, von denen mindestens eine Profilstrebe eine erste Montageseite mit einer Lochreihe aus ersten Befestigungsaufnahmen aufweist, und wobei mindestens eines der Sockeleckstücke eine zweite Montageseite mit einer Lochreihe aus zweiten Befestigungsaufnahmen aufweist. Eine derartige Anordnung ist aus der DE 10 2015 121 193 A1 bekannt. Eine ähnliche Anordnung beschreibt auch die DE 10 2011 013 158 A1.

Beim Schaltschrankausbau ist es grundsätzlich wünschenswert, die in dem Schaltschrank aufzunehmenden Komponenten möglichst platzsparend anzuordnen, wobei die Anordnung der Komponenten im Schaltschrankinnenraum weiterhin durch weitere Randbedingungen eingeschränkt sein kann, beispielsweise durch das Kabel- oder das Klimatisierungsmanagement. Es besteht somit der grundsätzliche Bedarf, dass der Schaltschrankinnenraum ein hochflexibles Ausbaukonzept aufweist, um auf die je nach Anwendungsfall stark variierenden Anforderungen reagieren zu können.

Es ist daher die Aufgabe der Erfindung, eine Anordnung der eingangs beschriebenen Art vorzuschlagen, die ein flexibles Innenausbaukonzept bereitstellt.

Diese Aufgabe wird durch eine Anordnung mit den Merkmalen des Anspruchs 1 gelöst. Der Anspruch 25 betrifft eine entsprechende Schaltschrankreihe und die abhängigen Ansprüche betreffen jeweils vorteilhafte Ausführungsformen der Erfindung.

Demgemäß ist vorgesehen, dass die zweiten Befestigungsaufnahmen unter demselben Rastermaß wie die ersten Befestigungsaufnahmen zueinander beabstandet sind.

Der Erfindung liegt somit die grundsätzliche Idee zugrunde, den bisher für den Schaltschrankinnenausbau weitestgehend ungenutzten Raum, der von dem Schaltschranksockel umschlossen wird, für die Anordnung von Schaltschrankausbaukomponenten nutzbar zu machen. Dadurch, dass die zweiten Befestigungsaufnahmen unter demselben Rastermaß wie die ersten Befestigungsaufnahmen angeordnet sind, können die bisher nur für den Innenausbau des Schaltschrankrahmengestells verwendeten Komponenten auch für den Ausbau des Schaltschranksockels verwendet werden.

So ist es bei einer Ausführungsform denkbar, dass die bei dem aus dem Stand der Technik bekannten Schaltschrankanordnungen verwendeten Bodenbleche, welche das von dem Rahmengestell umschlossene Volumen zum Sockel hin abschließen, weggelassen werden, so dass effektiv das von dem Schaltschranksockel umschlossene Volumen das von dem Schaltschrankrahmengestell umschlossene Volumen nach unten hin erweitert, so dass für den Innenausbau des Schaltschranks zusätzlicher Bauraum bereitgestellt wird. Es ist ebenso denkbar, dass die genannten Bodenbleche nur teilweise entfernt oder weggelassen werden, je nach dem, ob an der betreffenden Stelle gerade eine Innenausbaukomponente zwischen dem von dem Rahmengestell umschlossenen Volumen und dem Sockelvolumen hindurchgeführt werden soll.

Es ist insbesondere denkbar, dass mindestens eine Innenausbaukomponente, beispielsweise ein Montagechassis oder dergleichen, zwischen dem von dem Schaltschrankrahmengestell umschlossenen Schaltschrankinnenraum und dem von dem Schaltschranksockel umschlossenen Sockelraum geführt ist. Dabei kann die Innenausbaukomponente mit einem ersten Ende in dem von dem Rahmengestell umschlossenen Schaltschrankinnenraum und mit einem dem ersten Ende gegenüberliegenden zweiten Ende in dem von dem Schaltschranksockel umschlossenen Raum festgelegt sein. Geeignete Innenausbaukomponenten, beispielsweise Montagechassis, sind aus dem Stand der Technik bekannt.

Es ist vorteilhaft, wenn die ersten Befestigungsaufnahmen und die zweiten Befestigungsaufnahmen nicht nur in ihrer eigenen Lochreihe das Rastermaß einhalten, sondern darüber hinaus auch die Gesamtheit der ersten und die zweiten Befestigungsaufnahmen untereinander unter Einhaltung des Rastermaßes angeordnet ist. Dies kann dadurch erreicht werden, dass jeweils eine erste Befestigungsaufnahme und jeweils eine zweite Befestigungsaufnahme unter dem Rastermaß oder unter Einhaltung eines ganzzahligen Vielfachen des Rastermaßes zueinander beabstandet angeordnet sind. Weiterhin können die beiden Lochreihen in derselben Ebene angeordnet sein, so dass die beiden Lochreihen eine gemeinsame Montageebene aufweisen.

Die ersten und die zweiten Befestigungsaufnahmen können unter Einhaltung des Rastermaßes oder eines ganzzahligen Vielfachen des Rastermaßes zueinander beabstandet sein.

Wenn die Anordnung eine Innenausbaukomponente aufweist, kann diese mit einem ersten Befestigungsabschnitt in einem von dem Schaltschrankrahmengestell umbauten Volumen und mit einem zweiten Befestigungsabschnitt in einem von dem Schaltschranksockel umbauten Volumen festgelegt sein.

Alternativ kann die Innenausbaukomponente mit einem ersten Befestigungsabschnitt über eine der ersten Befestigungsaufnahmen an der ersten Montageseite der Profilstrebe montiert sein, wobei die Innenauskomponente mit einem zweiten Befestigungsabschnitt über eine der zweiten Befestigungsaufnahmen an der zweiten Montageseite des Sockeleckstücks festgelegt ist.

Alternativ kann die Innenausbaukomponente mit einem ersten Befestigungsabschnitt über eine der zweiten Befestigungsaufnahmen an der zweiten Montageseite des Sockeleckstücks festgelegt sein, während die Innenausbaukomponente mit einem zweiten Befestigungsabschnitt über eine der zweiten Befestigungsaufnahmen an der zweiten Montageseite eines weiteren der Sockeleckstücke festgelegt ist. Die beiden Lochreihen zweiter Befestigungsaufnahmen der Eckstücke können dabei einen Abstand zueinander aufweisen, der einem ganzzahligen Vielfachen des Rastermaßes entspricht. Die Innenausbaukomponente kann beispielsweise ein Montagechassis, eine Hohlschiene, eine Kabelabfangschiene sein, ist jedoch nicht auf diese beschränkt.

Der erste Befestigungsabschnitt der Innenausbaukomponente kann ein erstes Befestigungsmittel und der zweite Befestigungsabschnitt der Innenausbaukomponente kann ein zweites Befestigungsmittel aufweisen, wobei die Befestigungsmittel einen Abstand zueinander aufweisen, der einem ganzzahligen Vielfachen des Rastermaßes entspricht.

Zwei der Sockeleckstücke des Schaltschranksockels können mit jeweils einer Außenwand einander zugewandt angeordnet sein, wobei die Außenwände jeweils die die zweiten Befestigungsaufnahmen aufweisende zweite Montageseite aufweisen. Die Außenwände können dabei unter einem Abstand zueinander angeordnet sein, der einem ganzzahligen Vielfachen des Rastermaßes entspricht.

Das Sockeleckstück kann ein Formteil, insbesondere ein Blechformteil sein, mit einer ersten und einer zweiten Außenwand, die sich senkrecht zueinander erstrecken. Das Formteil kann weiterhin eine obere Deckseite und eine untere Bodenseite aufweisen, die parallel zueinander und senkrecht zu den Außenwänden angeordnet sind. Die Außenwände, die Deckseite und die Bodenseite können einen Innenraum des Sockeleckstücks abgrenzen, der zu einer Ecke des Formteils hin geöffnet ist.

Das Sockeleckstück kann ein Inlay aufweisen, insbesondere ein Kunststoffinlay, das sich in dem Innenraum zwischen der Deckseite und der Bodenseite erstreckt und das an seinem der Deckseite vorgelagerten Ende eine zu der Deckseite hin geöffnete Aufnahme aufweist, in der eine Gewindemutter, insbesondere ein K-Lock-Mutter, verdrehsicher aufgenommen ist.

Mit dem Sockeleckstück kann erreicht werden, dass die mechanische Tragefunktion des Sockeleckstücks für das Schaltschrankrahmengestell von dem Formteil bereitgestellt wird, während die weniger mechanische Belastung erfordernden Funktionalitäten, etwa die verdrehsichere Anordnung einer Gewindemutter im Innern des Formteils zur Montage des Formteils an der Unterseite eines Schaltschrankrahmengestells, von dem Inlay, welches insbesondere auch als Kunststoffinlay ausgebildet sein kann, bereitgestellt werden. Das Inlay kann je nach Ausführungsform zusätzliche Funktionen bereitstellen, beispielsweise Befestigungsmittel für die Montage einer Sockelblende an dem Sockeleckstück. Das Inlay ist bevorzugt ein optionales Bauteil, welches dazu eingerichtet ist, das Formteil bedarfsweise mit Zusatzfunktionen auszustatten.

Das Formteil und das Inlay können insbesondere als separate Bauteile bereitgestellt sein, so dass bei Ausführungsformen, bei welchen die durch das Inlay bereitgestellten Zusatzfunktionen nicht erforderlich sind, das Inlay weggelassen werden kann. Das Inlay kann insbesondere in einer Montageposition in dem Innenraum mit dem Formteil lösbar verbunden, insbesondere mit diesem verrastet oder an diesem über einen Formschluss gehalten sein.

Das Inlay kann derart im Innenraum des Sockeleckstücks angeordnet sein, dass ein Gewindedurchgang der Gewindemutter mit einem Durchbruch durch die Deckseite fluchtet, so dass der Gewindedurchgang von einer Außenseite des Sockeleckstücks, etwa für die Montage des Sockeleckstücks im Eckbereich und an der Unterseite eines Schaltschrankrahmengestells, zugänglich ist.

Die Deckseite kann eine muldenförmige Vertiefung zur formschlüssigen Aufnahme eine Gleitkufe aufweisen, wobei in der Vertiefung ein Durchbruch durch die Deckseite angeordnet ist, der mit einem Gewindedurchgang der Gewindemutter fluchtet. Die Gleitkufe kann an der Unterseite eines Schaltschrankrahmengestells vormontiert sein, so dass beim Aufsetzen des Schaltschrankrahmengestells auf einen aus vier Sockeleckstücken der eingangs beschriebenen Art vormontierten Schaltschranksockel, wobei die Sockeleckstücke beispielsweise über vier Sockelblenden zu einem rechteckigen Schaltschranksockel verbunden sind, die Gleitkufen eine einfache und exakte Vorpositionierung des Schaltschrankrahmengestells in Bezug auf den Schaltschranksockel ermöglichen, so dass etwa eine Durchgangsbohrung in einem Eckstück des Bodenrahmens des Schaltschrankrahmengestells mit dem Gewindedurchgang der Gewindemutter des Sockeleckstücks fluchtet und somit das Schaltschrankrahmengestell ohne aufwendige Ausrichtarbeit mit dem Schaltschranksockel verschraubt werden kann. Ein geeignetes Rahmengestell ist aus der DE 10 2015 121 193 A1 bekannt.

Die Außenwände können jeweils an ihrer freien Längskante eine U-Umkantung aufweisen, mit einer sich senkrecht zu der Außenwand erstreckenden ersten Profilseite und mit einer an die erste Profilseite angeformten zweiten Profilseite, die sich parallel zu der Außenwand erstreckt und eine im Innenraum angeordnete freie Kante aufweist. Die U-Umkantung kann eine weitere Funktionalität bereitstellen, beispielsweise eine Systemlochung aus regelmäßig beabstandeten Befestigungsaufnahmen, die beispielsweise dem Ausbau des Schaltschranksockels dienen können. Die U-Umkantung kann jedoch insbesondere auch dazu ausgelegt sein, die Festlegung von Sockelblenden am Sockeleckstück zu ermöglichen.

Die U-Umkantungen können beispielsweise an mindestens einer von erster und zweiter Profilseite eine in Vertikalrichtung verlaufende Systemlochung aus unter einem Rastermaß beabstandeten Befestigungsdurchbrüchen aufweisen, wobei ein Rahmengestell für einen Schaltschrank auf dem Sockeleckstück, vorzugsweise über eine Gleitkufe, aufgesetzt ist, wobei das Rahmengestell eine Profilstrebe mit einer weiteren Profilseite aufweist, die in derselben Ebene wie die die Systemlochung aufweisende Profilseite der U-Umkantung angeordnet ist, und wobei eine Systemlochung der weiteren Profilseite unter Einhaltung des Rastermaßes zu der Systemlochung der U-Umkantung angeordnet ist.

Durch die Einhaltung des durch das Schaltschrankrahmengestell vorgegebenen Rastermaßes bis in den Sockelbereich hinein kann bei einer Ausführungsform der Erfindung der von dem Schaltschrankrahmengestell umbaute Schaltschrankinnenraum um den von dem Schaltschranksockel umbauten Raum erweitert werden, wobei beispielsweise Montagechassis und derselben aufgrund der Durchgängigkeit des Rastermaßes bis in den Schaltschranksockel hinein zwischen dem Schaltschranksockel und dem Schaltschrankinnenraum geführt werden können, ohne dass Adapter oder andere Anpassungsmaßnahmen erforderlich wären.

Das Inlay kann ein erstes und ein zweites Paar unter einem Abstand zueinander angeordneter Führungsstifte aufweisen, wobei das erste Paar Führungsstifte mit seinen freien Enden an der zweiten Profilseite einer ersten der beiden U-Umkantungen anliegt, und wobei das zweite Paar Führungsstifte mit seinen freien Enden an der zweiten Profilseite einer zweiten der U-Umkantungen anliegt.

Das Inlay kann weiterhin ein erstes und ein zweites Befestigungsmittel, insbesondere ein erstes und ein zweites Paar zueinander vorspannbarer Rastklinken aufweisen, das sich mit seinem freien Ende zwischen jeweils einem der Paare Führungsstifte auf die jeweilige zweite Profilseite zu und parallel zu dieser erstreckt.

Insbesondere kann eine Sockelblende mit einer Befestigungslasche eine der beiden U-Umkantungen umgreifen, wobei sich ein freies Ende der Befestigungslasche senkrecht zu der Blendenvorderseite erstreckt, an der zweiten Profilseite einer der U-Umkantungen anliegt und vorzugsweise an der zweiten Profilseite festgelegt ist.

Das freie Ende der Befestigungslasche kann dabei an einer dem Innenraum zugewandten Kante eine hinterschnittige Ausnehmung aufweisen, in die ein Befestigungsmittel des Inlays, insbesondere ein paar Rastklinken eingreift.

Der Innenraum des Sockeleckstücks kann über eine Eckblende verschlossen sein, die an den ersten Profilseiten der U-Umkantungen parallel anliegt und mit jeweils einem Rasthaken an jeweils einer der beiden freien Kanten der beiden zweiten Profilseiten angreift.

Insbesondere können die beiden ersten Profilseiten der U-Umkantungen und die beiden zweiten Profilseiten der U-Umkantungen senkrecht zueinander ausgerichtet sein.

Das gesamte Formteil kann als ein gekantetes und gegebenenfalls in Überlappungsbereichen geschweißtes Blechformteil ausgebildet sein, wobei die U-Umkantungen als zweifache Abkantungen an einer äußeren Längskante der jeweiligen Außenwand ausgebildet sein können.

Die Außenwände können über eine Verbindungsseite des Formteils miteinander verbunden sein, wobei die Verbindungsseite einen mehreckigen Durchlass aufweist, in den das Inlay mit einem an seiner Rückseite ausgebildeten und der Verbindungsseite zugewandten Formschlussadapter eingreift. Das Inlay kann alternativ oder zusätzlich an seinem der Deckseite zugewandten Ende, an dem auch die Aufnahme für die Gewindemutter angeordnet ist, einen weiteren Formschlussadapter aufweisen, der in eine Ausnehmung der Deckseite eingreift. Statt des weiteren Formschlussadapters kann auch mindestens eine Quetschrippe an dem oberen oder dem unteren Ende des Inlays ausgebildet sein, mithilfe welcher das Inlay zwischen der Deckseite und der Bodenseite im Presssitz eingeklemmt werden kann. Insbesondere mit Hilfe der Formschlussadapter wird erreicht, dass das Inlay verdrehsicher in dem Formteil aufgenommen ist.

Während sich die Außenwände senkrecht zueinander erstrecken, kann sich die Verbindungsseite jeweils unter einem 45°-Winkel zu den beiden Außenwänden erstrecken. Die Verbindungsseite kann eine den Abstand der Außenwände zueinander bestimmende Breite aufweisen, die wesentlich geringer als eine Länge der Verbindungsseite in Richtung senkrecht zu der Deckseite und der Bodenseite ist. Die Verbindungsseite kann eine sich in Vertikalrichtung, das heißt in Verbindungsrichtung zwischen Deckseite und Bodenseite, erstreckende Lochung aus regelmäßig beabstandeten Befestigungsaufnahmen aufweisen.

Ein Gewindebolzen kann sich zwischen der Deckseite und der Bodenseite sowie durch die Deckseite hindurch erstrecken, mit einer Nivellierhülse, die auf den Gewindebolzen aufgeschraubt und zwischen der Deckseite und der Bodenseite angeordnet ist und an die ein Nivelliersockel angeformt ist, der sich durch die Bodenseite hindurch erstreckt. An der Bodenseite des Formteils kann eine Transportrolle festgelegt sein, die zwischen einer Transportstellung und einer Lagerstellung verschwenkt werden kann, wobei in der Lagerstellung eine Aufstandsebene der Transportrolle in einer Aufstandsebene des Sockeleckstücks oder darüber liegt und wobei in der Transportstellung die Aufstandsebene der Transportrolle unterhalb der Aufstandsebene des Sockeleckstücks liegt.

Eine Sockelblende des Schaltschranksockels kann an gegenüberliegenden Längskanten jeweils eine zweite U-Umkantung aufweisen, wobei die zweiten U-Umkantungen jeweils eine freie Montageseite aufweisen. Die freien Montageseiten können an einer Rückseite der Sockelblende parallel beabstandet zu einer Vorderseite der Sockelblende und in einer gemeinsamen Ebene angeordnet sein. Die freien Montageseiten können jeweils eine Lochreihe aus weiteren Befestigungsaufnahmen aufweisen, wobei die Lochreihen parallel zueinander verlaufen und vorzugsweise einen Abstand zueinander aufweisen, der einem ganzzahligen Vielfachen des Rastermaßes entspricht. Auch die die Lochreihen der freien Montageseiten bildenden weiteren Befestigungsaufnahmen können untereinander einen Abstand einhalten, der dem Rastermaß entspricht.

Der Schaltschranksockel kann zweite Sockelblenden aufweisen, die sich gegenüberliegend mit ihren zweiten U-Umkantungen einander zugewandt angeordnet sind. Über ein Paar gegenüberliegender freier Montageseiten der zweiten U-Umkantungen der beiden Sockelblenden kann ein Bodenblech an den beiden Sockelblenden und sich zwischen diesen erstreckend befestigt sein, wobei vorzugsweise über einen an den Sockelblenden befestigten Befestigungswinkel eine Auflage und eine Befestigungsebene für das Bodenblech bereitgestellt sind.

Eine Sockelblende des Schaltschranksockels kann ein Kippschutz für die Anordnung sein, indem die Sockelblende zwischen benachbarten Sockeleckstücken in Horizontalausrichtung montiert ist, in welcher die Sockelblende mit ihrer Vorderseite oder ihrer Rückseite auf einer Unterlagen, auf der die Anordnung aufsteht, aufliegt und mit einer Längskante über das lichte Außenmaß des Rahmengestells sowie gegebenenfalls daran montierter Flachteile hinausragt.

Eine Schaltschrankreihe besteht aus mindestens zwei der Anordnungen der zuvor beschriebenen Art, bei der zwei in Tiefenrichtung der Schaltschrankreihe zueinander beabstandet angeordnete Paare aus einander zugewandten Sockeleckstücken benachbarter Schaltschranksockel über eine in Tiefenrichtung verlaufende erste Sockelblende miteinander verbunden sind.

Die erste Sockelblende kann horizontal ausgerichtet und ihre Vorderseite der Unterlagen, auf der die Schaltschrankreihe steht, zugewandt sein.

Die Schaltschrankreihe kann eine zu der ersten Sockelblende identische zweite Sockelblende aufweisen, die vertikal ausgerichtet ist und sich zwischen zwei Sockeleckstücken desselben Schaltschranksockels erstreckt. Es kann insbesondere vorgesehen sein, dass die für die Schaltschrankanreihung verwendeten Sockelblenden als Gleichteile zu den den Schaltschranksockel verblendenden Sockelblenden ausgebildet sind.

Die erste Sockelblende kann entlang ihrer beiden Längskanten jeweils eine zweite U-Umkantung mit einer freien Montageseite aufweisen, die an einer Rückseite der Sockelblende unter einem Abstand zu einer Vorderseite der Sockelblende parallel zu der Vorderseite verläuft und eine in ihrer Erstreckungsrichtung verlaufende Lochreihe aus weiteren Befestigungsaufnahmen aufweist. Die weiteren Befestigungsaufnahmen können unter Einhaltung des Rastermaßes zueinander beabstandet sein. Weiterhin können die beiden Lochreihen parallel zueinander verlaufen und einen Abstand zueinander aufweisen, der einem ganzzahligen Vielfachen des Rastermaßes entspricht.

Die erste und die zweite Sockelblende können identisch ausgebildet sein und entlang ihrer beiden Längskanten jeweils eine zweite U-Umkantung aufweisen, wobei jeweils ein Befestigungsflansch an die zweiten U-Umkantungen angeformt ist, der sich senkrecht zu allen drei Seiten der zweiten U-Umkantung erstreckt. Der Befestigungsflansch kann mindestens ein Befestigungsmittel aufweisen, über den die Sockelblende an einem Sockeleckstück festgelegt werden kann. Es kann insbesondere vorgesehen sein, dass sowohl die erste Sockelblende für die Schaltschrankanreihung als auch die zweite Sockelblende für die Schaltschranksockelverblendung jeweils über ihren Befestigungsflansch an einem der Sockeleckstücke, beispielsweise auch an demselben Sockeleckstück , jedoch an um 90° zueinander versetzten Außenseitendes Sockeleckstücks festgelegt ist.

Einer der Schaltschranksockel der Schaltschrankreihe kann an gegenüberliegenden Seiten jeweils eine erste Sockelblende aufweisen, wobei die Sockelblenden an aneinander zugewandten Längskanten jeweils eine Systemlochreihe aufweisen, die parallel zueinander verlaufen und einen Abstand zueinander aufweisen, der einem ganzzahligen Vielfachen des Rastermaßes entspricht. Eine Innenausbaukomponente, etwa eine Kabelabfangschiene oder ein Montagechassis, kann sich zwischen den Längskanten erstrecken und mit gegenüberliegenden Befestigungsabschnitten an den Systemlochreihen festgelegt sein. Die Systemlochreihen können insbesondere jeweils in einer freien Montageseite einer zweiten U-Umkantung an einer Längsseite der jeweiligen Sockelblende ausgebildet sein.

Weitere Einzelheiten der Erfindung werden anhand der nachstehenden Figuren erläutert. Dabei zeigt:
- Figur 1: in perspektivischer Darstellung ein Formteil eines Sockeleckstücks sowie eine Gleitkufe gemäß einer Ausführungsform;
- Figur 2: in perspektivischer Darstellung einen Schaltschranksockel mit darauf aufgesetztem Rahmengestell sowie einem Sockeleckstück gemäß einer weiteren Ausführungsform;
- Figur 3: in perspektivischer Darstellung eine Ausführungsform einer erfindungsgemäßen Anordnung aus einem Sockeleckstück und einem darauf aufgesetztem Schaltschrankrahmengestell mit Blick auf die Rückseite des Formteils;
- Figur 4: in perspektivischer Darstellung ein Inlay für ein Sockeleckstück gemäß einer Ausführungsform;
- Figur 5: in perspektivischer Darstellung ein Formteil eines Sockeleckstücks gemäß einer Ausführungsform, an dem zwei Sockelblenden gemäß einer ersten Befestigungsvariante festgelegt sind;
- Figur 6: in perspektivischer Darstellung ein Formteil eines Sockeleckstücks gemäß einer Ausführungsform, an dem zwei Sockelblenden gemäß einer zweiten Befestigungsvariante festgelegt sind;
- Figur 7: eine Anordnung aus vier Formteilen gemäß einer Ausführungsform in perspektivischer Darstellung einer Anreihsituation benachbarter Schaltschranksockel;
- Figur 8: in perspektivischer Darstellung eine weitere Ausführungsform eines Formteils eines Sockeleckstücks, an dem ein Nivellierfuß befestigt ist;
- Figur 9: eine Querschnittsansicht eines Formteils eines Sockeleckstücks gemäß einer Ausführungsform, an dem eine Eckblende befestigt ist;
- Figur 10: eine Sockelanordnung für eine Schaltschrankreihe;
- Figur 11: eine Detailansicht der Darstellung gemäß Figur 10 im Bereich der Verbindung zwischen den aneinander grenzenden Schaltschranksockeln;
- Figur 12: eine beispielhafte Ausführungsform einer Innenausbausituation eines Schaltschranksockels;
- Figur 13: eine erfindungsgemäße Anordnung mit einer am Sockel befestigten Transportrolle; und
- Figur 14: in perspektivischer Darstellung einen Schaltschranksockel mit darauf aufgesetztem Rahmengestell sowie einem Sockeleckstück gemäß einer weiteren Ausführungsform;
- Figur 15: eine Seitenansicht eines doppelten Schaltschranksockels mit darauf aufgesetztem Rahmengestell gemäß einer weiteren Ausführungsform; und
- Figur 16: in perspektivischer Darstellung einen Schaltschranksockel mit darauf aufgesetztem Rahmengestell sowie einer an dem Sockel befestigten Innenausbaukomponente.

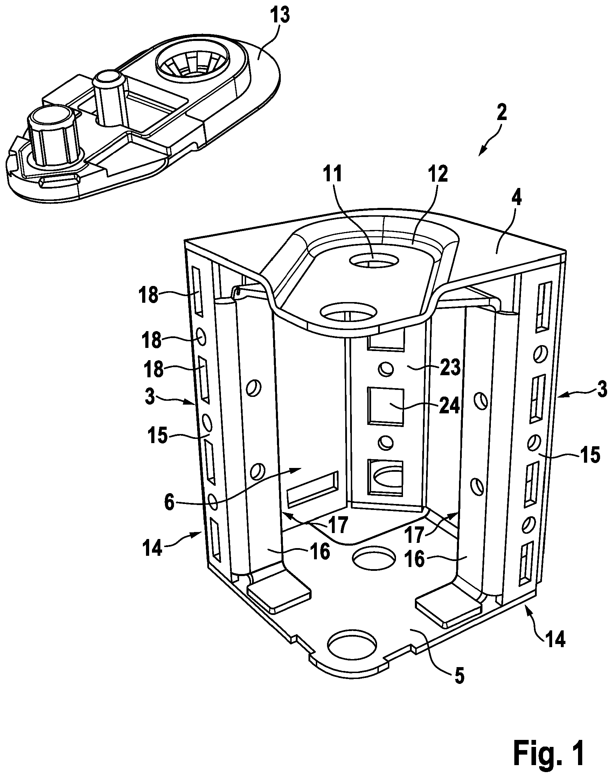

Figur 1 zeigt eine beispielhafte Ausführungsform eines Formteils 2 für ein Sockeleckstück gemäß einer Ausführungsform der Erfindung. Das Formteil 2 ist als ein Blechformteil ausgebildet.

Das Blechformteil 2 besteht im Wesentlichen aus einer Deckseite 4, einer Bodenseite 5 sowie zwei Außenwänden 3, die sich senkrecht zu der Deckseite 4 und der Bodenseite 5 erstrecken und diese unter einem Abstand miteinander verbinden. Die Außenwände 3 sind über eine Verbindungsseite 23 miteinander verbunden, die sich jeweils unter einem 45°-Winkel zu den Außenwänden 3 erstreckt. Die Außenwände 3 und die Verbindungsseite 23 sind einteilig ausgeführt und die Verbindungsseite 23 weist eine Lochung aus regelmäßig beabstandeten Rechteckdurchbrüchen 24 auf.

Die Deckseite 4 weist eine muldenförmige Vertiefung 12 auf, in die eine Gleitkufe 13 formschlüssig eingesetzt werden kann. Die Gleitkufe 13 kann beispielsweise an der Unterseite des Rahmengestells eines Schaltschranks vormontiert werden, so dass aufgrund der formschlüssigen Konturen von Gleitkufe 13 und muldenförmiger Vertiefung 12 die Vorpositionierung des Schaltschrankrahmengestells auf dem Sockeleckstück, insbesondere auf der Deckseite 4 des Blechformteils 2 erleichtert wird, so dass ein komfortables Verschrauben von Blechformteil 2 und Schaltschrankrahmengestell möglich ist.

An den von der Verbindungsseite 23 abgewandten freien Enden weisen die Außenwände 3 jeweils eine U-Umkantung 14 auf, mit einer sich senkrecht zu der Außenwand 3 erstreckenden ersten Profilseite 15 und einer an die erste Profilseite 15 angeformten zweiten Profilseite 16, die sich parallel zu der Außenwand 3 erstreckt und eine im Innenraum 6 angeordnete freie Kante 17 aufweist, die gegenüber der Außenwand 3 beabstandet ist. Die erste Profilseite 15 weist eine Systemlochung 18 aus regelmäßig beabstandeten rechteckigen und runden Durchbrüchen auf. Die zweite Profilseite 16 weist weitere Rundlöcher auf, die insbesondere für die Festlegung von Sockelblenden dienen können.

Das Blechformteil 2 kann durch Stanzen, Kanten und Schweißen eines Metallblechs erhalten werden, wobei die muldenförmige Vertiefung 12 beispielsweise im Zuge eines Prägevorgangs ausgebildet werden kann. Das Blechformteil 2 ist damit im Vergleich zu aus dem Stand der Technik bekannten Spritzgusssockeleckstücken kostengünstig herstellbar.

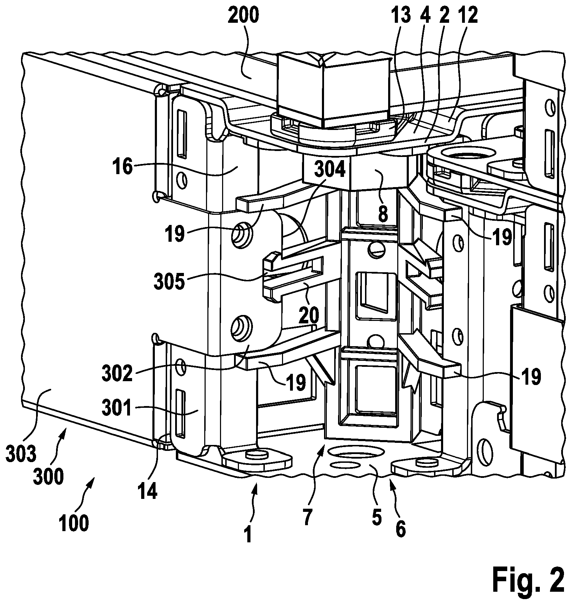

Bei der in Figur 2 gezeigten Ausführungsform ist in den Innenraum 6 des Formteils 2 ein Inlay 7 eingesetzt, welches sich über die vollständige Distanz zwischen der Deckseite 4 und der Bodenseite 5 erstreckt und insbesondere in dieser Dimension formschlüssig, gegebenenfalls im Presssitz, zwischen der Deckseite 4 und der Bodenseite 5 aufgenommen werden kann. Der Deckseite 4 zugewandt weist das Inlay 7 eine Aufnahme 8 für eine Gewindemutter, insbesondere für eine K-Lock-Mutter auf. Das Formteil 2 kann dasselbe sein, wie es mit Bezug auf Figur 1 beschrieben worden ist. Ein Rahmengestell 200 ist auf die Deckseite 4 sowie im Bereich der Vertiefung 12 über eine Gleitkufe 13 auf dem Formteil 2 aufgesetzt. Eine Sockelblende 300 umgreift mit einer Befestigungslasche 301 eine der beiden U-Umkantungen 14, wobei das Inlay 7 ein erstes und ein zweites Paar unter einem Abstand zueinander angeordneter Führungsstifte 19 aufweist, von denen ein erstes Paar Führungsstifte 19 mit seinen freien Enden an der zweiten Profilseite 16 einer ersten der beiden U-Umkantungen 14 anliegt, und wobei ein zweites Paar Führungsstifte 19 mit seinen freien Enden an der zweiten Profilseite 16 einer zweiten der beiden U-Umkantungen 14 anliegt. Weiterhin weist das Inlay 7 ein erstes und ein zweites Paar zueinander vorspannbarer Rastklinken 20 auf, die sich mit ihren freien Enden zwischen jeweils einem der Paare Führungsstifte 19 auf die jeweilige zweite Profilseite 16 zu und parallel zu dieser erstrecken.

Eine Sockelblende 300 umgreift mit ihrer Befestigungslasche 301 eine der beiden U-Umkantungen 14, wobei sich eine freies Ende 302 der Befestigungslasche 301 senkrecht zu der Blendenvorderseite 303 erstreckt und an der zweiten Profilseite 16 einer der U-Umkantungen 14 anliegt. Das freie Ende 302 der Befestigungslasche 301 weist an seiner dem Innenraum zugewandten Kante 304 eine hinterschnittige Ausnehmung 305 auf, in die die zueinander vorspannbaren Rastklinken 20 des Inlays 7 eingreift, so dass die Sockelblende 300 durch Aufrasten an dem Sockeleckstück 1 festlegbar ist.

Bei Bedarf weisen die zweite Profilseite 16 sowie das freie Ende 302 der Befestigungsseite 301 fluchende Durchlässe auf, über die die Sockelblende 300 für eine noch festere Verbindung mit dem Formteil 2 verschraubt werden könnte. Bei dem Aufsetzen der Sockelblende 300 auf das Formteil mit Hilfe des Paares Führungsstifte 19 wird eine Vorausrichtung der hinterschnittigen Ausnehmung 305 auf die zueinander vorspannbaren Rastklinken 20 im Zuge des Annäherns von Blende und Sockeleckstück 1 aneinander erreicht, so dass mit dem Aufeinandertreffen von Rastklinken 20 und Ausnehmung 305 die beiden versatzfrei ineinander greifen können.

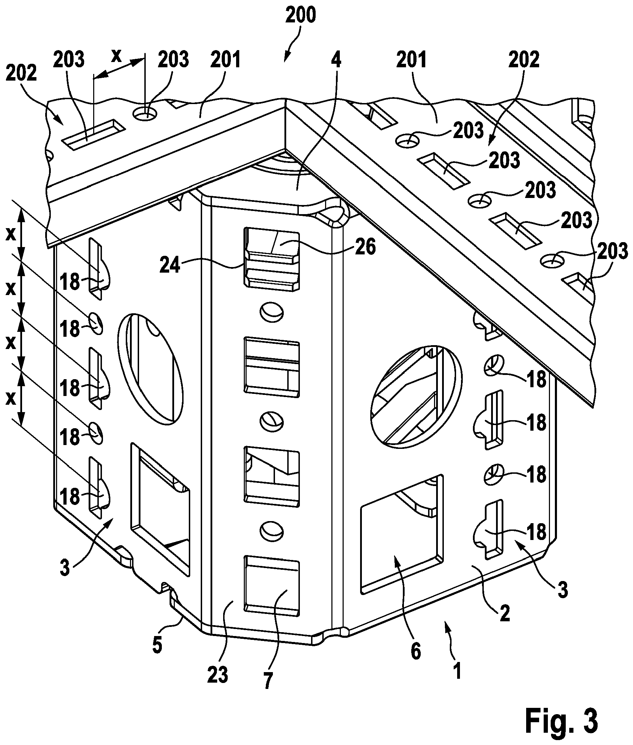

Figur 3 zeigt eine Sicht auf die Rückseite eines Formteils 2 einer Ausführungsform der Erfindung mit darauf aufgesetztem Schaltschrankrahmen 200. Grundsätzlich kann der Schaltschrankrahmen, insbesondere die Bodenbaugruppe dieses eine Geometrie aufweisen, wie sie aus der DE 10 2015 121 193 A1 bekannt ist. Das Schaltschrankrahmengestell 200 weist eine Mehrzahl Profilstreben 201 auf, die jeweils eine erste Montageseite 202 mit einer Lochreihe aus ersten Befestigungsaufnahmen 203 aufweisen. Das Sockeleckstück 1 weist eine zweite Montageseite 3 mit einer Lochreihe aus zweiten Befestigungsaufnahmen 18 auf, wobei die ersten und die zweiten Befestigungsaufnahmen 18, 203 unter demselben Rastermaß x zueinander beabstandet sind.

Wie zu erkennen ist, sind die Außenwände 3 über eine Verbindungsseite 23 miteinander verbunden, wobei sich die Verbindungsseite 23 jeweils unter dem 45°-Winkel zu den Außenwänden 3 erstreckt. Die Verbindungsseite 23 weist eine weitere Systemlochung aus regelmäßig beabstandeten mehreckigen Durchlässen 24 auf. In den obersten Durchlass 24 greift das Inlay 7 mit einem an seiner Rückseite ausgebildeten und der Verbindungsseite 23 zugewandter Formschlussadapter ein. Auf diese Weise ist das Inlay 7 verdrehsicher im Innenraum 6 des Formteils 2 aufgenommen.

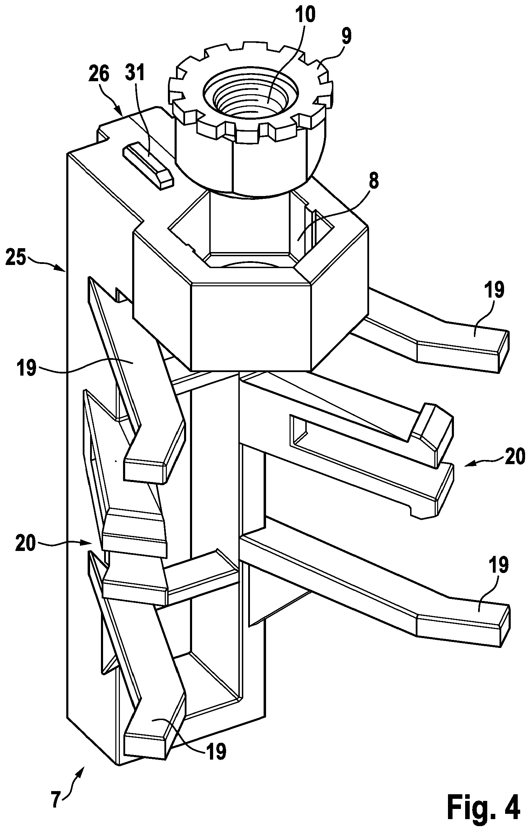

In Figur 4 ist eine perspektivische Detailansicht eines beispielhaften Inlays 7 gezeigt. Dieses kann beispielsweise als ein Spritzgussformteil ausgebildet sein. Wie mit Bezug auf Figur 3 beispielhaft beschrieben worden ist, kann das Inlay 7 an seiner Rückseite 25 einen Formschlussadapter 26 aufweisen. Ein weiterer Formschlussadapter 31 kann an einem oberen Ende des Inlays ausgebildet sein, wobei das Inlay 7 über den weiteren Formschlussadapter 31 in eine Aufnahme in der Deckseite 4 des Formteils (nicht dargestellt) eingreifen kann, um einen ergänzenden Verdrehschutz des Inlays 7 im Inneren des Formteils zu erreichen.

Das Inlay 7 weist weiterhin eine zur Oberseite des Inlays 7, mithin zur Deckseite 4 eines Formteils hin geöffnete Aufnahme 8 auf, in die eine Gewindemutter 9 mit einem Innengewinde 10 eingesetzt ist. Die Gewindemutter 9 kann insbesondere als eine K-Lock-Mutter ausgebildet sein.

Wie bereits mit Bezug auf Figur 2 beschrieben worden ist, so kann das Inlay 7 neben einem ersten und einem zweiten Paar Führungsstifte 19 ein erstes und ein zweites Befestigungsmittel 20 aufweisen, wobei Letzteres im vorliegenden Fall aus jeweils einem Paar zueinander vorspannbarer Rastklinken ausgebildet ist. Während jeweils ein Paar Führungsstifte 19 dazu vorgesehen ist, zwischen sich eine Befestigungslasche einer Sockelblende in Bezug auf das Befestigungsmittel 20 vorauszurichten, wenn die Sockelblende an das Eckstück herangeführt wird, um die Sockelblende an dem Eckstück festzulegen, sind die Befestigungsmittel 20 mit ihren endseitigen Rastklinken dazu ausgelegt, um in einer hinterschnittigen Ausnehmung in einer dem Innenraum des Sockeleckstücks zugewandten Kante der Befestigungslasche einzugreifen und damit die Sockelblende an dem jeweiligen Sockeleckstück festzulegen.

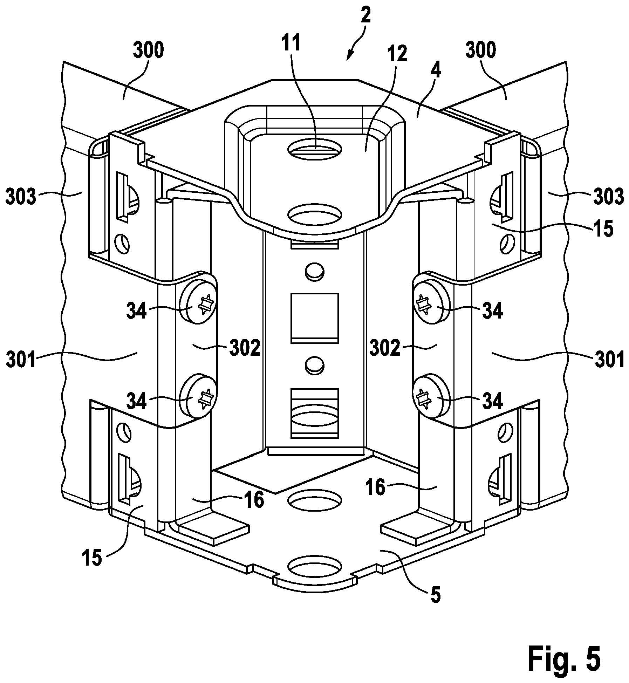

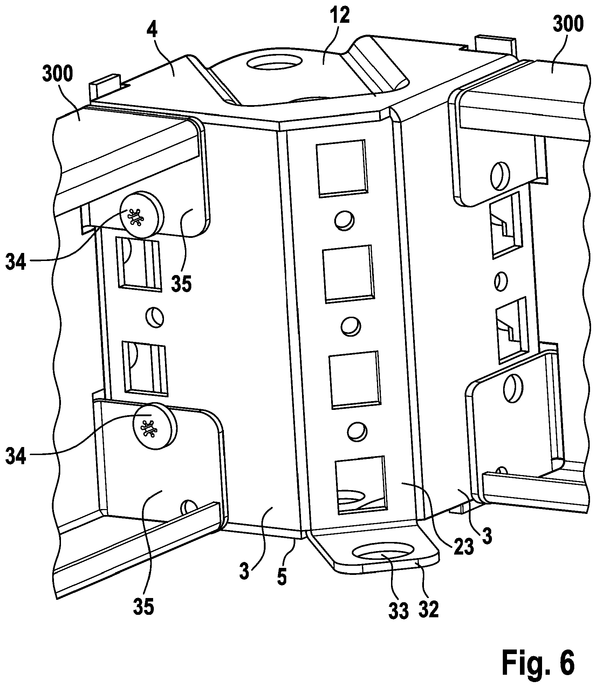

Die Figuren 5 und 6 zeigen zwei weitere Ausführungsformen für die Befestigung einer Sockelblende 300 an einem Formteil 2 eines erfindungsgemäßen Sockeleckstücks. Während bei der in Figur 5 gezeigten Ausführungsform die Sockelblende 300 über die freien Enden 302 ihrer Befestigungslasche 301 an der zweiten Profilseite 16 einer U-Umkantung 14 des Formteils 2 verschraubt sind, sind bei der in Figur 6 gezeigten Ausführungsform die Sockelblenden 300 unmittelbar an den Außenwänden 3 verschraubt, wozu die Sockelblenden 300 Befestigungsflansche 35 mit jeweils mindestens einem Bolzendurchlass aufweisen, über welche die Sockelblende 300 mit zwei Schraubbolzen 34 an den Außenwänden 3 festgelegt werden können. Senkrecht zu der Verbindungsseite 23 erstreckt sich in Richtung des Inneren des von dem Schaltschranksockel umbauten Raums eine Befestigungslasche 32 mit einer Bohrung 33, mit Hilfe welcher bedarfsweise das Sockeleckstück, insbesondere das Formteil 2 dieses auf einer Unterlage verschraubt werden kann.

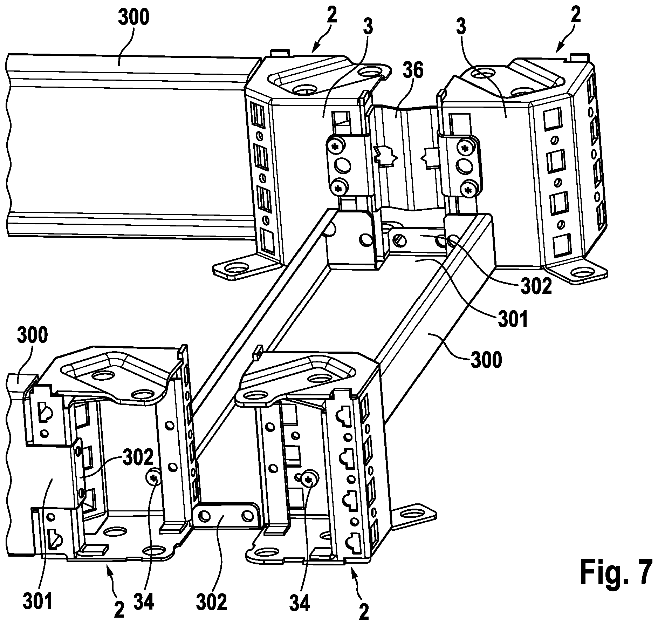

Die Figur 7 zeigt eine Anreihsituation, bei der zwei Varianten für die Befestigung von aneinander grenzenden Sockeleckstücken, insbesondere Formteilen 2 benachbarter Schaltschranksockelrahmen veranschaulicht sind. Während einerseits ein Anreihverbinder 36 die aneinander grenzenden Formteile 2 über ihre parallelen Außenwände 3 miteinander verbindet, indem jeweils Schraubverbindungen zwischen dem Anreihverbinder 36 und der Außenseite 3 beider Formteile 2 hergestellt sind, dient bei der in der Darstellung gemäß Figur 7 vorderen Paarung von zwei Formteilen 2 eine Sockelblende 300 für die Anreihung zweier Formteile 2. Das freie Ende 302 beziehungsweise die Befestigungslasche 301 kann eine breite, senkrechte zur Längsrichtung der Sockelblende 300 aufweisen, welche einem Sollabstand der beiden aneinander grenzenden Formteile 2 in der Anreihsituation entspricht, so dass diese über die Sockelblende 300 exakt zueinander vorpositioniert werden können, insbesondere derart, dass Schraubbolzenverbindungen 34 zwischen den beiden Formteilen 2 und der Sockelblende 300 hergestellt werden können.

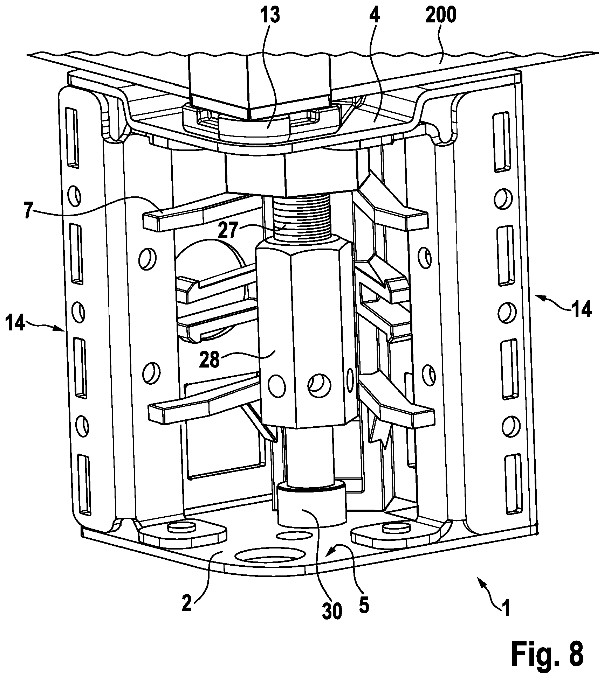

Figur 8 zeigt ein Sockeleckstück 1 mit einem im Inneren des Sockeleckstücks 1 aufgenommen Nivellierenfuß, der einen Gewindebolzen 27 aufweist, der sich zwischen der Deckseite 4 und der Bodenseite 5 des Sockeleckstücks 1 sowie durch die Deckseite 4 hindurcherstreckt. Der Nivellierfuß weist weiterhin eine Nivellierhülse 28 auf, die auf den Gewindebolzen 27 aufgeschraubt ist und zwischen der Deckseite 4 und der Bodenseite 5 angeordnet ist. An dem der Bodenseite 5 zugewandten Ende ist an die Nivellierhülse 28 ein Nivelliersockel 30 angeformt, der sich durch die Bodenseite 5 hindurch erstreckt. Der Gewindebolzen 27 kann an einem freien Ende (nicht dargestellt), mit dem er durch die Deckseite hindurchtritt, eine durch das Rahmengestell 200 hindurch zugängliche Kontermutter (nicht dargestellt) aufweisen, über welche der Nivellierfuß gegenüber dem Rahmengestell 200 beziehungsweise gegenüber der Deckseite 4 in einer über die Nivellierhülse 28 eingestellten Nivellierposition festgelegt werden kann.

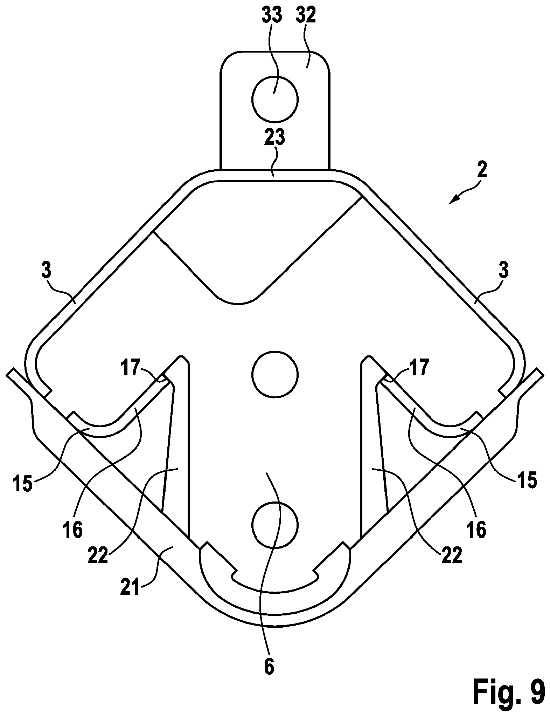

Die Figur 9 zeigt eine beispielhafte Ausführungsform für die Befestigung einer Sockeleckblende 21 an einem Formteil 2 eines erfindungsgemäßen Sockeleckstücks. Der Innenraum 6 des Sockeleckstücks 1 ist erkennbar über die Eckblende 21 verschlossen, wobei die Eckblende 21 an der ersten Profilseite 15 der U-Umkantungen 14 parallel anliegt und mit jeweils einem Rasthaken 22 an jeweils einer der freien Kanten 17 der beiden zweiten Profilseiten angreift. Die Rasthaken 22 erstrecken sich parallel zueinander und jeweils unter einem 45°-Winkel zu derjenigen Seite der Eckblende 21, an der sie angeformt sind. Die Eckblende 21 besteht im Wesentlichen aus zwei einteilig ausgeformten und sich senkrecht zueinander erstreckenden Teilwandabschnitten, wobei sich ein erster der beiden Rasthaken 22 unter einem 45°-Winkel zu einem ersten der beiden Teilwandabschnitte und ein zweiter der beiden Rasthaken 22 unter einem 45°-Winkel zu einem zweiten der beiden Teilwandabschnitte erstreckt.

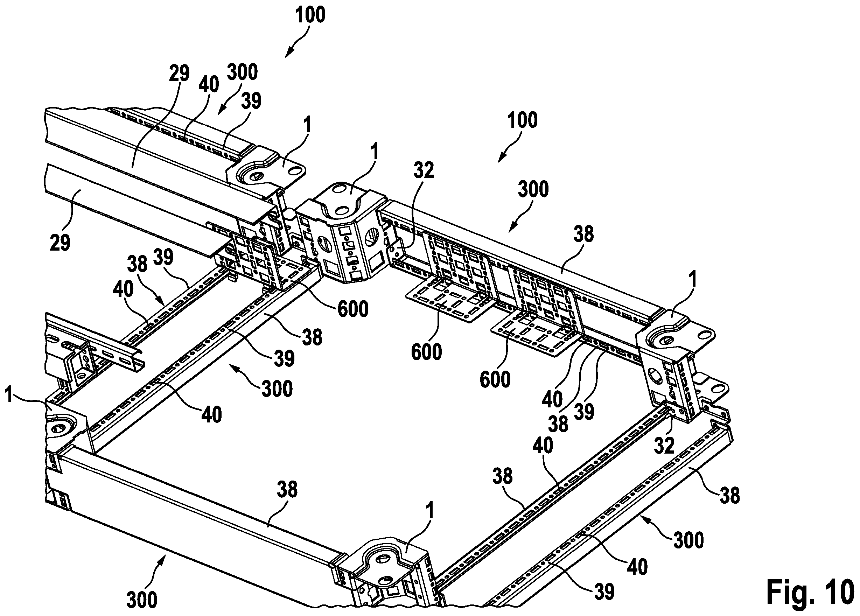

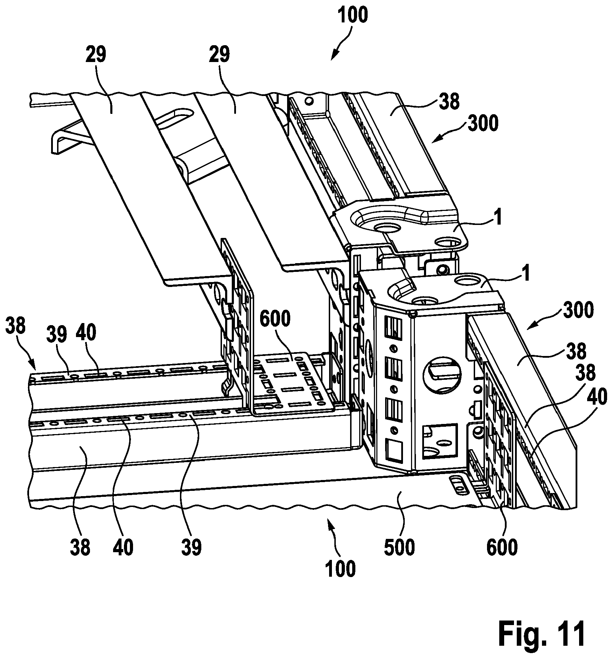

Figuren 10 und 11 zeigen eine Anordnung aus zwei miteinander verbundenen Schaltschranksockeln 100. Die Schaltschranksockel bestehen im Wesentlichen aus vier Sockeleckstücken 1, die an den vier Ecken des jeweiligen Sockels 100 angeordnet und über Sockelblenden 300 miteinander verbunden sind. Es ist zu erkennen, dass erste Sockelblenden 300 in Vertikalausrichtung jeweils zwei sich gegenüber stehende Sockeleckstücke desselben Schaltschranksockels 100 miteinander verbinden und somit die klassische Verblendfunktion des Schaltschranksockels bereitstellen. An dem Übergang zwischen den beiden Schaltschranksockeln 100 wird eine weitere, baugleiche Sockelblende 300 dazu verwendet, um die beiden Sockel 100 miteinander zu verbinden. Dazu ist die die aneinander grenzenden Sockel 100 über die sich gegenüberliegenden Eckstücke 1 miteinander verbindende Sockelblende 300 horizontal ausgerichtet, wobei sie mit ihrer Vorderseite der Unterlage des Schaltschranksockels 100 zugewandt ist, und wobei an der Rückseite der Sockelblende 300 eine weitere U-Umkantung 38 ausgebildet ist, deren freie Montageseite 39 eine Systemlochung 40 aus regelmäßig beabstandeten Befestigungsaufnahmen 40 aufweist. Die Befestigungsaufnahmen 40 können ebenfalls unter Einhaltung des Rastermaßes angeordnet sein. Ein Befestigungswinkel 600 ist über die Montageseiten 39 an der horizontal ausgerichteten Sockelblende 300 festgelegt, wobei der Montagewinkel 600 wiederum für die Befestigung einer Kabelabfangschiene 29 dient. Eine weitere Kabelabfangschiene 29 ist unmittelbar an einem der Sockeleckstücke 1 festgelegt.

Zwei weitere Befestigungswinkel 600, die identisch zu dem bereits genannten Befestigungswinkel 600 für die Befestigung der Kabelabfangschiene ausgebildet sein können, dienen für die Bereitstellung einer Montageebene für Bodenbleche, um einen Abschluss des um das Volumen des Schaltschranksockels erweiterten Schaltschrankinnenraums nach unten hin bereitzustellen.

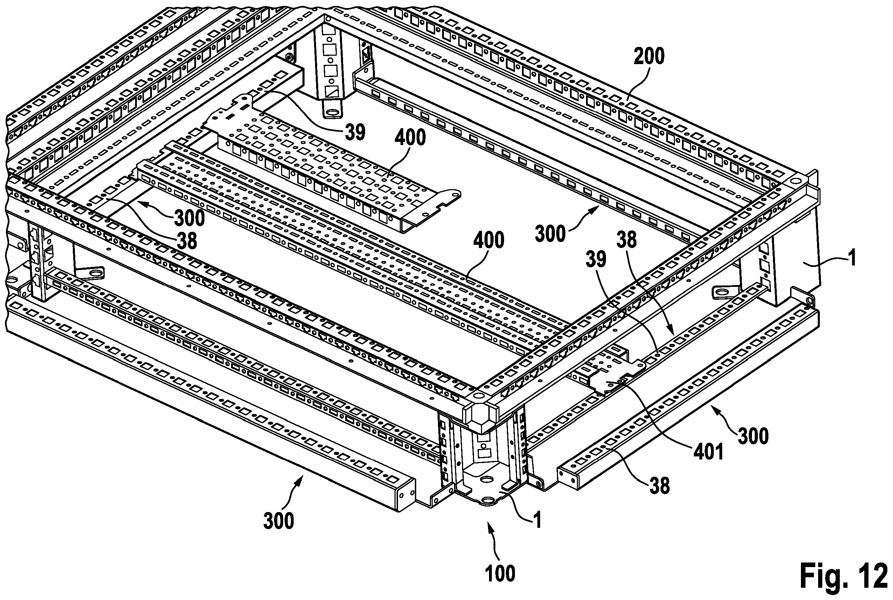

Die Figur 12 zeigt eine weitere Ausführungsform eines Schaltschranksockels 100, bei dem die vier in den Ecken des Schaltschranksockels angeordneten Eckstücke 1 über vier Sockelblenden 300 zu einem rechteckigen Sockelrahmen miteinander verbunden sind. Hierbei sind die Sockelblenden jedoch horizontal ausgerichtet und mit ihrer Vorderseite der Unterlage des Sockels 100 zugewandt angeordnet. An der gezeigten Rückseite weisen die Sockelblenden 300 an ihren gegenüberliegenden Längskanten jeweils eine zweite U-Umkantung 38 auf, wobei die U-Umkantungen 38 eine gegenüber der Vorderseite der Sockelblende 300 beabstandete Montageseite 39 mit Befestigungsaufnahmen aufweist.

Es ist zu erkennen, dass eine Innenausbaukomponente 400, insbesondere ein Montagechassis, zwischen zwei gegenüberliegenden Sockelblenden 300 geführt ist und mit jeweils einem Befestigungsabschnitt 401 an der zweiten U-Umkantung 38, insbesondere an der jeweiligen freien Montageseite 39 dieser festgelegt ist. Dabei weisen die beiden Lochreihen der Befestigungsaufnahmen 39, über die die Innenausbaukomponente 400 über ihre gegenüberliegenden Befestigungsabschnitte 401 an den die gegenüberliegenden Sockelblenden 300 festgelegt ist, einen Abstand zueinander auf, der einem ganzzahligen Vielfachen des Rastermaßes entspricht. Demzufolge kann die Innenausbaukomponente 400 eine gängige Innenausbaukomponente sein, welche beispielsweise für den Innenausbau des Schaltschranks verwendet werden kann, so dass für den Ausbau des Schaltschranksockels 100 keine besonderen Innenausbaukomponenten mit besonderen Befestigungsmitteln erforderlich sind.

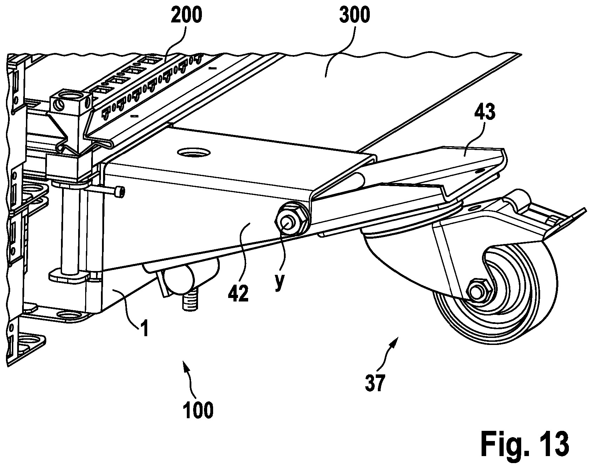

Die Figur 13 zeigt einen Schaltschranksockel 100, bei dem an einem Eckstück 1 eine Transportrolle 37 festgelegt ist. Insbesondere weist die Transportrolle einen Befestigungskeil 42 auf, über den die Transportrolle 37 an dem Eckstück 1 befestigt ist, und der an seinem von dem Eckstück 1 abgewandten Ende ein Schwenklager aufweist, über welches eine Rollenauflage 43 um eine Schwenkachse y gegenüber dem Befestigungskeil verschwenkbar ist. An einer der Auflage des Schaltschranksockels 100 zugewandten Unterseite der Rollenauflage 43 ist eine Rolle über ein Horizontallager befestigt. Die Transportrolle 37 ist zwischen einer Transportstellung und einer Lagerstellung verschwenkbar, wobei in der Lagerstellung eine Aufstandsebene der Transportrolle 37 in einer Aufstandsebene des Sockeleckstücks oder darüber liegt und wobei in der Transportstellung die Aufstandsebene der Transportrolle unterhalb der Aufstandsebene des Sockeleckstücks liegt. Um die Transportrolle zwischen den beiden genannten Stellpositionen zu verstellen, ist sie bedarfsweise um die Schwenkachse y verschwenkbar.

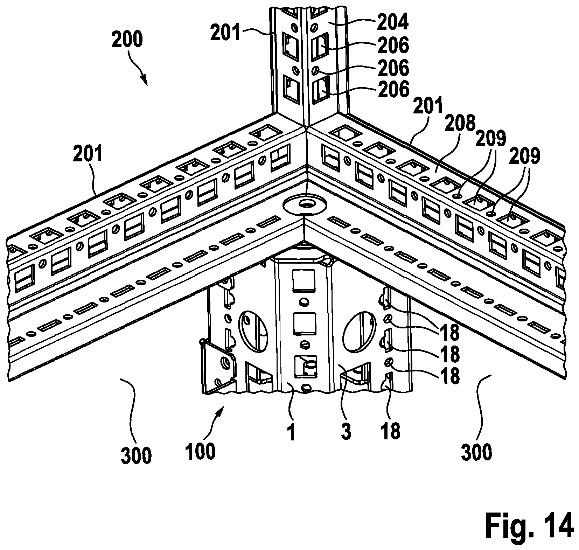

Die Figur 14 zeigt in perspektivischer Darstellung eine weitere erfindungsgemäße Anordnung aus einem Schaltschranksockel 100 mit einem darauf montierten Schaltschrankrahmengestell 200, wobei die Anordnung im Eckbereich gezeigt ist, mit Blick auf das zentrale Eckstück 1, an dem zwei Sockelblenden 300 festgelegt sind, die sich unter einem 90°-Winkel zueinander erstrecken. Das Eckstück 1 ist im Wesentlichen identisch zu dem Eckstück gemäß Figur 3 ausgebildet Demgemäß weist das Eckstück 1 an einer Außenwand 3 eine Systemlochung 18 aus regelmäßig und unter einem Rastermaß beabstandeten Befestigungsaufnahmen auf.

Eine Vertikalstrebe 201 des Rahmengestells 200 weist eine zum Innenraum des von dem Rahmengestell 200 umschlossenen Volumens gewandte Profilseite 201 mit weiteren Befestigungsaufnahmen 206 auf, die ebenso eine Systemlochung aus regelmäßig und unter demselben Rastermaß beabstandeten Befestigungsaufnahmen 206 bildet.

Die Profilseite 204 und die Außenwand 3 erstrecken sich parallel zueinander, ebenso wie die Systemlochungen 18 und 206. Die Außenwand 3 und die Profilseite 204 weisen einen senkrechten Abstand zueinander auf, der ebenfalls einem Vielfachen des Rastermaßes entspricht. Dadurch wird beispielsweise erreicht, dass eine Montageebene einer Innenausbaukomponente, beispielsweise die Montageebene eines Montagechassis, welches über die Systemlochung 18 an dem Eckstück 1 festgelegt ist, einen Abstand zu der Profilseite 204 und der darin ausgebildeten Systemlochung aus Befestigungsaufnahmen 206 aufweist, der ebenfalls einem ganzzahligen Vielfachen des Rastermaßes entspricht. Ebenso können etwaige Befestigungsaufnahmen, die in dem Montagechassis ausgebildet sind, unter Einhaltung des Rastermaßes in Bezug auf die Befestigungsaufnahmen 206 angeordnet sein, so dass das Rastermaß zwischen dem von dem Rahmengestell 200 umschlossenen Schaltschrankvolumen und dem von dem Sockel 100 umschlossenen Sockelvolumen durchgängig erhalten ist und damit der Sockelbereich vollwertig für den Innenausbau des Schaltschranks geeignet ist.

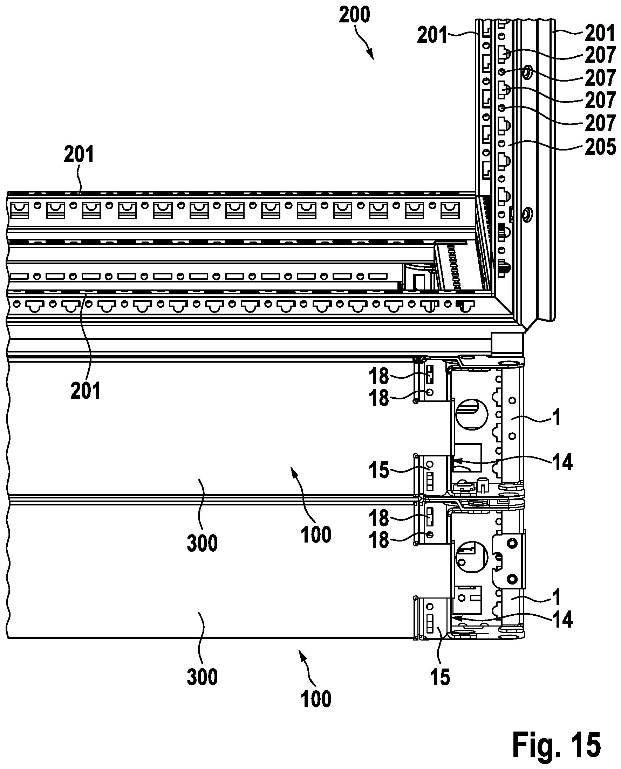

Die Figur 15 zeigt eine Anordnung aus einem Schaltschrankrahmengestell 200, welches auf zwei übereinander gestapelten Schaltschranksockeln 1 angeordnet ist. Die Eckstücke 1 der Schaltschranksockel 100 können wiederum entsprechend Figur 1 oder Figur 3 ausgebildet sein und weisen dementsprechend eine erste U-Umkantung 14 mit einer eine Systemlochung 18 aufweisenden ersten Profilseite 15 auf. Die Systemlochung 18 der ersten Profilseite 15 erstreckt sich vertikal, wobei die Befestigungsaufnahmen der Systemlochung 18 unter dem Rastermaß angeordnet sind. Ebenso weist das in der Darstellung vordere Vertikalprofil 201 des Rahmengestells 200, welches sich oberhalb von den beiden Sockeleckstücken 1 erstreckt, an einer Profilseite 205 eine sich vertikal erstreckende Systemlochung aus Befestigungsaufnahmen 207 auf, die ebenso unter dem Rastermaß angeordnet sind. Weiterhin sind die Profilseite 205 und die erste Profilseite 15 in derselben Ebene angeordnet, so dass die Befestigungsaufnahmen 18 der ersten Profilseite 15 und die weiteren Befestigungsaufnahmen 207 der Profilseite 205 in derselben Montageebene liegen. Innerhalb dieser Montageebene weisen die beiden sich parallel zueinander erstreckenden Systemlochungen aus den Befestigungsaufnahmen 18 und den Befestigungsaufnahmen 207 einen Abstand zueinander auf, der wiederum einem ganzzahligen Vielfachen des Rastermaßes entspricht.

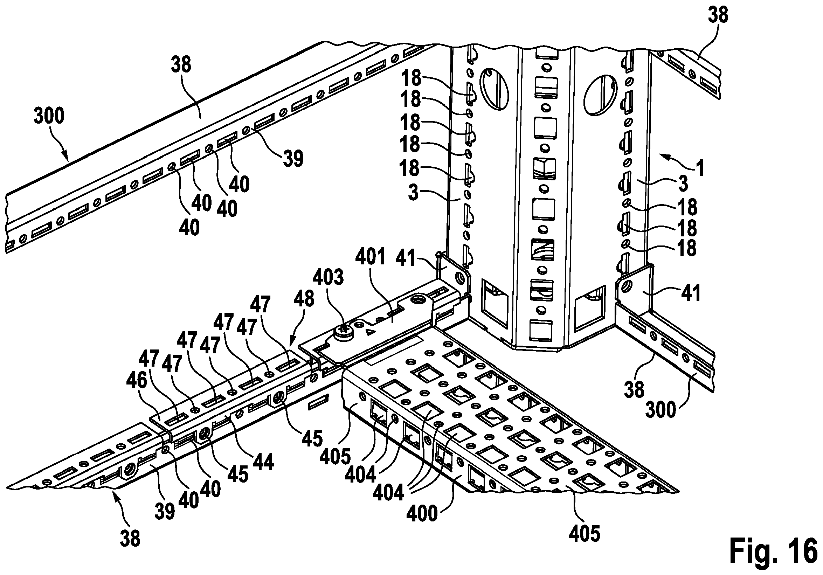

In Figur 16 ist eine weitere Anordnung gezeigt, bei der über die freie Montageseite 39 der zweiten U-Umkantungen 38 der Sockelblende 300 ein Montagewinkel 48 festgelegt ist. Der Montagewinkel 48 weist eine Befestigungsseite 44 und eine sich senkrecht dazu erstreckende Montageseite 46 auf. Über die Befestigungsseite 44 ist der Montagewinkd 48 an der freien Montageseite 39 festlegbar. Dazu weist die Befestigungsseite 44 Befestigungsaufnahmen 45 auf, über die beispielsweise Bolzen durch die Befestigungsseite 44 und die freie Montageseite 39 hindurch geschraubt werden können.

Die Montageseite 46 weist eine Systemlochung aus regelmäßig beabstandeten Befestigungsaufnahmen 47 auf, wobei die Befestigungsaufnahmen 47 unter dem Rastermaß zueinander beabstandet sind und im Übrigen in dem Rastermaß der weiteren Befestigungsaufnahmen 40 der freien Montageseite 39 angeordnet sind, so dass die Befestigungsaufnahmen 47 der Montageseite 46 in dem Rastermaß des Gesamtsystems angeordnet sind. Über die Montageseite 46 ist eine Innenausbaukomponente 400, hier ein Montagechassis, an der Sockelblende 300 festgelegt. Dazu weist die Innenausbaukomponente 400 einen ersten Befestigungsabschnitt 401 und einen gegenüberliegenden zweiten Befestigungsabschnitt (nicht dargestellt) auf. Der gezeigte erste Befestigungsabschnitt 401 ist über die Montageseite 46 mit der Sockelblende verschraubt. Dazu weist die Innenausbaukomponente 400 ein Befestigungsmittel 403 auf, hier einen Gewindebolzen.

Aufgrund der rastermaßhaltigen Anordnung des Montagewinkels 48 an der zweiten U-Umkantung 38 der Sockelblende 300 sind auch die weiteren Befestigungsaufnahmen 404 auf den Montageseiten 405 des Montagechassis 400 in dem Rastermaß des Gesamtsystems angeordnet.

### Bezugszeichenliste:

- 1: Sockeleckstück
- 2: Formteil
- 3: Außenwand
- 4: Deckseite
- 5: Bodenseite
- 6: Innenraum
- 7: Inlay
- 8: Aufnahme
- 9: Gewindemutter
- 10: Gewindedurchgang
- 11: Durchbruch
- 12: Vertiefung
- 13: Gleitkufe
- 14: erste U-Umkantung
- 15: erste Profilseite
- 16: zweite Profilseite
- 17: Kante
- 18: Systemlochung
- 19: Führungsstift
- 20: Befestigungsmittel
- 21: Eckblende
- 22: Rasthaken
- 23: Verbindungsseite
- 24: Durchlass
- 25: Rückseite
- 26: Formschlussadapter
- 27: Gewindebolzen
- 28: Nivellierhülse
- 29: Kabelabfangschiene
- 30: Nivelliersockel
- 31: weiterer Formschlussadapter
- 32: Befestigungslasche
- 33: Bohrung
- 34: Schraubbolzen
- 35: Befestigungsflansch
- 36: Anreihverbinder
- 37: Transportrolle
- 38: zweite U-Umkantung
- 39: freie Montageseite
- 40: weitere Befestigungsaufnahme
- 41: Befestigungsflansch
- 42: Befestigungskeil
- 43: Rollenauflage
- 44: Befestigungsseite
- 45: Befestigungsaufnahme
- 46: Montagseite
- 47: Befestigungsaufnahme
- 48: Montagewinkel
- 100: Schaltschranksockel
- 200: Rahmengestell
- 201: Profilstrebe
- 202: Profilseite
- 203: Befestigungsaufnahme
- 204: Profilseite
- 205: Profilseite
- 206: Befestigungsaufnahme
- 207: Befestigungsaufnahme
- 208: Profilseite
- 209: Befestigungsaufnahme
- 300: Sockelblende
- 301: Befestigungslasche
- 302: freies Ende
- 303: Blendenvorderseite
- 304: Kante
- 305: Ausnehmung
- 400: Innenausbaukomponente
- 401: erster Befestigungsabschnitt
- 402: zweiter Befestigungsabschnitt
- 403: Befestigungsmittel
- 404: Befestigungsaufnahmen
- 405: Montagebene
- 500: Bodenblech
- 600: Befestigungswinkel
- x: Rastermaß
- y: Schwenkachse

## Patentansprüche

1. Anordnung aus einem Schaltschranksockel (100) und einem darauf montierten Schaltschrankrahmengestell (200), wobei der Schaltschranksockel (100) mehrere Sockeleckstücke (1) aufweist, die an dem Schaltschrankrahmengestell (200) festgelegt sind, und das Schaltschrankrahmengestell (200) eine Mehrzahl Profilstreben (201) aufweist, von denen mindestens eine Profilstrebe (201) eine erste Montageseite (202, 204, 205, 208) mit einer Lochreihe aus ersten Befestigungsaufnahmen (203, 206, 207, 209) aufweist, und wobei mindestens eines der Sockeleckstücke (1) eine zweite Montageseite (3, 15, 16, 23) mit einer Lochreihe aus zweiten Befestigungsaufnahmen (18) aufweist, **dadurch gekennzeichnet, dass** die zweiten Befestigungsaufnahmen (18) unter demselben Rastermaß (x) wie die ersten Befestigungsaufnahmen (203, 206, 207, 209) zueinander beabstandet sind.

2. Anordnung nach Anspruch 1, bei der mindestens eine der folgenden Bedingungen erfüllt ist:
a. die erste und die zweite Montageseite (3, 15, 16, 23, 202) sind in derselben Ebene angeordnet;
b. die beiden Lochreihen sind um das Rastermaß (x) oder ein ganzzahliges Vielfaches des Rastermaßes (x) voneinander beabstandet.

3. Anordnung nach einem der Ansprüche 1 oder 2, die weiterhin eine Innenausbaukomponente (400) aufweist, die
a. mit einem ersten Befestigungsabschnitt (401) in einem von dem Schaltschrankrahmengestell (200) umbauten Volumen und mit einem zweiten Befestigungsabschnitt (402) in einem von dem Schaltschranksockel (100) umbauten Volumen festgelegt ist, oder
b. mit einem ersten Befestigungsabschnitt (401) über eine der ersten Befestigungsaufnahmen (203, 206, 207, 209) an der ersten Montageseite (202, 204, 208) der Profilstrebe (201) montiert ist, und die mit einem zweiten Befestigungsabschnitt (402) über eine der zweiten Befestigungsaufnahmen (18) an der zweiten Montageseite (3, 15, 16, 23) des Sockeleckstücks (1) festgelegt ist, oder
c. mit einem ersten Befestigungsabschnitt (401) über eine der zweiten Befestigungsaufnahmen (18) an der zweiten Montageseite (3, 15, 16, 23) des Sockeleckstücks (1) festgelegt ist, und die mit einem zweiten Befestigungsabschnitt (402) über eine der zweiten Befestigungsaufnahmen (18) an der zweiten Montageseite (3, 15, 16, 23) eines weiteren der Sockeleckstücke (1) festgelegt ist, wobei die beiden Lochreihen der zweiten Befestigungsaufnahmen (18) der Sockeleckstücke (1) einen Abstand zueinander aufweisen, der einem ganzzahligen Vielfachen des Rastermaßes (x) entspricht.

4. Anordnung nach Anspruch 3, bei dem der erste Befestigungsabschnitt (401) der Innenausbaukomponente (400) ein erstes Befestigungsmittel (403) und der zweite Befestigungsabschnitt (402) der Innenausbaukomponente (400) ein zweites Befestigungsmittel (403) aufweist, wobei die Befestigungsmittel (403) einen Abstand zueinander aufweisen, der einem ganzzahligen Vielfachen des Rastermaßes (x) entspricht.

5. Anordnung nach einem der vorangegangen Ansprüche, bei der zwei der Sockeleckstücke (1) des Schaltschranksockels (100) mit jeweils einer Außenwand (3) einander zugewandt angeordnet sind, wobei die Außenwände (3) jeweils die die zweiten Befestigungsaufnahmen (18) aufweisende zweite Montageseite (3, 15, 16, 23) aufweisen, und wobei die Außenwände (3) unter einem Abstand zueinander angeordnet sind, der einem ganzzahligen Vielfachen des Rastermaßes (x) entspricht.

6. Anordnung nach einem der vorangegangen Ansprüche, bei der das Sockeleckstück (1) ein Formteil (2), insbesondere ein Blechformteil, aufweist, das eine erste und eine zweite Außenwand (3) aufweist, die sich senkrecht zueinander erstrecken, und das weiterhin eine obere Deckseite (4) und eine untere Bodenseite (5) aufweist, die parallel zueinander und senkrecht zu den Außenwänden (3) angeordnet sind, wobei die Außenwände (3), die Deckseite (4) und die Bodenseite (5) einen Innenraum (6) des Sockeleckstücks (1) abgrenzen, der zu einer Ecke des Formteils (2) hin geöffnet ist.

7. Anordnung nach Anspruch 6, bei der das Sockeleckstück (1) weiterhin ein Inlay (7), insbesondere ein Kunststoffinlay aufweist, das sich in dem Innenraum (6) zwischen der Deckseite (4) und der Bodenseite (5) erstreckt und das an seinem der Deckseite (4) vorgelagerten Ende eine zu der Deckseite (4) hin geöffnete Aufnahme (8) aufweist, in der eine Gewindemutter (9) verdrehsicher aufgenommen ist.

8. Anordnung nach Anspruch 7, bei der das Inlay (7) in einer Montagposition in dem Innenraum (6) mit dem Formteil (2) lösbar verbunden, insbesondere verrastet ist.

9. Anordnung nach Anspruch 7 oder 8, bei der ein Gewindedurchgang (10) der Gewindemutter (9) mit einem Durchbruch (11) durch die Deckseite (4) fluchtet und über diesen zugänglich ist.

10. Anordnung nach einem der Ansprüche 7 bis 9, bei der die Deckseite (4) eine muldenförmige Vertiefung (12) zur formschlüssigen Aufnahme einer Gleitkufe (13) aufweist, wobei in der Vertiefung (12) ein Durchbruch (11) durch die Deckseite (4) angeordnet ist, der mit einem Gewindedurchgang (10) der Gewindemutter (9) fluchtet.

11. Anordnung nach einem der Ansprüche 6 bis 10, bei der die Außenwände (3) jeweils an ihrer freien Längskante eine erste U-Umkantung (14) aufweisen, mit einer sich senkrecht zu der Außenwand (3) erstreckenden ersten Profilseite (15) und einer an die erste Profilseite (15) angeformten zweiten Profilseite (16), die sich parallel zu der Außenwand (3) erstreckt und eine im Innenraum (6) angeordnete freie Kante (17) aufweist.

12. Anordnung nach Anspruch 11, bei der die ersten U-Umkantungen (14) an mindestens einer von erster und zweiter Profilseite (15, 16) die zweite Montageseite aufweisen.

13. Anordnung nach Anspruch 11, bei der das Inlay (7) ein erstes und ein zweites Paar unter einem Abstand zueinander angeordneter Führungsstifte (19) aufweist, wobei das erste Paar Führungsstifte (19) mit seinen freien Enden an der zweiten Profilseite (16) einer ersten der beiden ersten U-Umkantungen (14) anliegt, und wobei das zweite Paar Führungsstifte (19) mit seinen freien Enden an der zweiten Profilseite (16) einer zweiten der beiden ersten U-Umkantungen (14) anliegt.

14. Anordnung nach Anspruch 13, bei der das Inlay (7) weiterhin ein erstes und ein zweites Befestigungsmittel (20), insbesondere ein erstes und ein zweites Paar zueinander vorspannbarer Rastklinken aufweist, das sich mit seinem freien Ende zwischen jeweils einem der Paare Führungsstifte (19) auf die jeweilige zweite Profilseite (16) zu und parallel zu dieser erstreckt.

15. Anordnung nach einem der Ansprüche 11 bis 14, bei der eine Sockelblende (300) mit einer Befestigungslasche (301) eine der beiden U-Umkantungen (14) umgreift, wobei sich ein freies Ende (302) der Befestigungslasche (301) senkrecht zur Blendenvorderseite (303) erstreckt, an der zweiten Profilseite (16) einer der ersten U-Umkantungen (14) anliegt und vorzugsweise an der zweiten Profilseite (16) festgelegt ist.

16. Anordnung nach Anspruch 15, bei der das freie Ende (302) der Befestigungslasche (301) an einer dem Innenraum (6) zugewandten Kante (304) eine hinterschnittige Ausnehmung (305) aufweist, in die ein Befestigungsmittel (20) des Inlays (7), insbesondere ein Paar Rastklinken, eingreift.

17. Anordnung nach einem der Ansprüche 11 bis 16, bei der der Innenraum (6) des Sockeleckstücks (1) über eine Eckblende (21) verschlossen ist, die an den ersten Profilseiten (15) der ersten U-Umkantungen (14) parallel anliegt und mit jeweils einem Rasthaken (22) an jeweils einer der beiden freien Kanten (17) der beiden zweiten Profilseiten (16) angreift.

18. Anordnung nach einem der Ansprüche 11 bis 17, bei der die beiden ersten Profilseiten (15) der ersten U-Umkantungen (14) und die beiden zweiten Profilseiten (16) der ersten U-Umkantungen (14) senkrecht zueinander stehen.

19. Anordnung nach Anspruch 5, bei der die Außenwände (3) über eine Verbindungsseite (23) des Formteils (2) miteinander verbunden sind, wobei die Verbindungsseite (23) einen mehreckigen Durchlass (24) aufweist, in den das Inlay (7) mit einem an seiner Rückseite (25) ausgebildeten und der Verbindungsseite (23) zugewandten Formschlussadapter (26) eingreift.

20. Anordnung nach Anspruch 6, bei der sich ein Gewindebolzen (27) zwischen der Deckseite (4) und der Bodenseite (5) sowie durch die Deckseite (4) hindurch erstreckt, mit einer Nivellierhülse (28), die auf den Gewindebolzen (27) aufgeschraubt und zwischen der Deckseite (4) und der Bodenseite (5) angeordnet ist und an die ein Nivelliersockel (30) angeformt ist, der sich durch die Bodenseite (5) hindurch erstreckt.

21. Anordnung nach Anspruch 6, bei der an dem Formteil (2) eine Transportrolle (37) festgelegt ist, die zwischen einer Transportstellung und einer Lagerstellung verschwenkt werden kann, wobei in der Lagerstellung eine Aufstandsebene der Transportrolle (37) in einer Aufstandsebene des Sockeleckstücks (1) oder darüber liegt, und wobei in der Transportstellung die Aufstandsebene der Transportrolle (37) unterhalb der Aufstandsebene des Sockeleckstücks (1) liegt.

22. Anordnung nach einem der vorangegangen Ansprüche, bei der eine Sockelblende (300) des Schaltschranksockels (100) an gegenüber liegenden Längskanten jeweils eine zweite U-Umkantung (38) aufweist, wobei die zweiten U-Umkantungen (38) jeweils eine freie Montageseite (39) aufweisen, die an einer Rückseite der Sockelblende (300) parallel beabstandet zu einer Vorderseite der Sockelblende (300) und in einer gemeinsamen Ebene angeordnet sind, wobei die freien Montageseiten (39) jeweils eine Lochreihe aus weiteren Befestigungsaufnahmen (40) aufweisen, und wobei die Lochreihen parallel zueinander verlaufen und einen Abstand zueinander aufweisen, der einem ganzzahligen Vielfachen des Rastermaßes (x) entspricht.

23. Anordnung nach Anspruch 22, bei der der Schaltschranksockel zwei der Sockelblenden (300) aufweist, die sich gegenüber liegend mit ihren zweiten U-Umkantungen (38) einander zugewandt angeordnet sind, wobei über ein Paar gegenüber liegender freier Montageseiten (39) der zweiten U-Umkantungen (38) der beiden Sockelblenden (300) ein Bodenblech (500) an den beiden Sockelblenden (300) und sich zwischen diesen erstreckend befestigt ist, wobei vorzugsweise über einen an den Sockelblenden (300) befestigten Befestigungswinkel (600) eine Auflage und eine Befestigungsebene für das Bodenblech (500) bereitgestellt sind.

24. Anordnung nach einem der vorangegangen Ansprüche, bei der eine Sockelblende (300) des Schaltschranksockels ein Kippschutz für die Anordnung ist, indem die Sockelblende (300) zwischen benachbarten Sockeleckstücken (1) in Horizontalausrichtung montiert ist, in welcher die Sockelblende (300) mit ihrer Vorderseite oder ihrer Rückseite auf einer Unterlage, auf der die Anordnung aufsteht, aufliegt und mit einer Längskante über das lichte Außenmaß des Rahmengestells (200) sowie gegebenenfalls daran montierter Flachteile hinaus ragt.

25. Schaltschrankreihe bestehend aus mindestens zwei der Anordnungen nach einem der vorangegangenen Ansprüche, bei der zwei in Tiefenrichtung der Schaltschrankreihe zueinander beabstandet angerordnete Paare aus einander zugewandten Sockeleckstücken (1) benachbarter Schaltschranksockel (100) über eine in Tiefenrichtung verlaufende erste Sockelblende (300) miteinander verbunden sind.

26. Schaltschrankreihe nach Anspruch 25, bei der die erste Sockelblende (300) horizontal ausgerichtet und ihre Vorderseite der Unterlage, auf der die Schaltschrankreihe steht, zugewandt ist.

27. Schaltschrankreihe nach Anspruch 25 oder 26, bei der die Schaltschrankreihe eine zu der ersten Sockelblende (300) identische zweite Sockelblende (300) aufweist, die vertikal ausgerichtet ist und sich zwischen zwei Sockeleckstücken (1) desselben Schaltschranksockels (100) erstreckt.

28. Schaltschrankreihe nach einem der Ansprüche 25 bis 27, bei dem die erste Sockelblende (300) entlang ihrer beiden Längskanten jeweils eine zweite U-Umkantung (38) mit einer freien Montageseite (39) aufweist, die an einer Rückseite der Sockelblende (300) unter einem Abstand zu einer Vorderseite der Sockelblende (300) parallel zu der Vorderseite verläuft und eine in ihrer Erstreckungsrichtung verlaufende Lochreihe aus weiteren Befestigungsaufnahmen (40) aufweist, wobei die Lochreihen parallel zueinander verlaufen und einen Abstand zueinander aufweisen, der einem ganzzahligen Vielfachen des Rastermaßes (x) entspricht.

29. Schaltschrankreihe nach Anspruch 27, bei der die erste und die zweite Sockelblende (300) identisch ausgebildet sind und entlang ihrer beiden Längskanten jeweils eine zweite U-Umkantung (38) aufweisen, wobei jeweils ein Befestigungsflansch (41) an die zweiten U-Umkantungen angeformt ist, der sich senkrecht zu allen drei Profilseiten der zweiten U-Umkantung (38) erstreckt.

30. Schaltschrankreihe nach Anspruch 26, bei der einer der Schaltschranksockel (100) an gegenüber liegenden Seiten jeweils eine erste Sockelblende (300) aufweist, wobei die Sockelblenden (300) an einander zugewandten, Längskanten (38) jeweils eine Systemlochreihe (18) aufweisen, die parallel zueinander verlaufen und einen Abstand zueinander aufweisen, der einem ganzzahligen Vielfachen des Rastermaßes (x) entspricht, und wobei sich eine Innenausbaukomponente (400), etwa eine Kabelabfangschiene oder ein Montagechassis, zwischen den Längskanten erstreckt und mit gegenüber liegenden Befestigungsabschnitten (401) an den Systemlochreihen (18) festgelegt ist.

## Claims

1. An arrangement of a switch cabinet base (100) and a switch cabinet frame rack (200) mounted thereon, wherein the switch cabinet base (100) comprises a plurality of base corner pieces (1) fixed to the switch cabinet frame rack (200), and the switch cabinet frame rack (200) comprises a plurality of profile struts (201), at least one profile strut (201) of which comprises a first mounting side (202, 204, 205, 208) with a row of holes of first mounting receptacles (203, 206, 207, 209), and wherein at least one of the base corner pieces (1) comprises a second mounting side (3, 15, 16, 23) with a row of holes of second mounting receptacles (18), **characterized in that** the second mounting receptacles (18) are spaced apart by the same grid dimension (x) as the first mounting receptacles (203, 206, 207, 209).

2. The arrangement according to claim 1, in which at least one of the following conditions is met:
a. the first and the second mounting side (3, 15, 16, 23, 202) are arranged in the same plane;
b. the two rows of holes are spaced apart from each other by the grid dimension (x) or an integer multiple of the grid dimension (x).

3. The arrangement according to any of claims 1 or 2, which further comprises an interior installation component (400), which
a. is fixed with a first fastening section (401) in a volume enclosed by the switch cabinet frame rack (200) and with a second fastening section (492( in a volume enclosed by the switch cabinet base (100), or
b. is mounted with a first fastening section (401) via one of the first mounting receptacles (203, 206, 207, 209) on the first mounting side (202, 204, 208) of the profile strut (201), and which is fixed with a second fastening section (402) via one of the second mounting receptacles (18) on the second mounting side (3, 15, 16, 23) of the base corner piece (1), or
c. is fixed with a first fastening section (401) via one of the second mounting receptacles (18) to the second mounting side (3, 15, 16, 23) of the base corner piece (1), and which is fixed with a second fastening section (402) via one of the second mounting receptacles (18) to the second mounting side (3, 15, 16, 23) of another of the base corner pieces (1), wherein the two rows of holes of the second mounting receptacles (18) of the corner pieces (1) have a distance to each other which corresponds to an integer multiple of the grid dimension (x).

4. The arrangement according to claim 3, in which the first fastening section (401) of the interior installation component (400) has a first fastening means (403) and the second fastening section (402) of the interior installation component (400) h a second fastening means, wherein the fastening means (403) comprise a distance which is an integer multiple of the grid dimension (x) to each other.

5. The arrangement according to any of the preceding claims, in which two of the base corner pieces (1) of the switch cabinet base (100) are each arranged facing each other with an outer wall (3), wherein the outer walls (3) each comprise the second mounting side (3, 15, 16, 23) comprising the second mounting receptacles (18), and wherein the outer walls (3) are arranged at a distance from each other which corresponds to an integer multiple of the grid dimension (x).

6. The arrangement according to any of the preceding claims, in which the base corner piece (1) comprises a shaped part (2), in particular a sheet metal shaped part, which has a first and a second outer wall (3) which extend perpendicular to each other, and which further has an upper cover side (4) and a lower bottom side (5) which are arranged parallel to each other and perpendicular to the outer walls (3), wherein the outer walls (3), the cover side (4) and the bottom side (5) delimit an interior space (6) of the base corner piece (1) which is open towards a corner of the shaped part (2).

7. The arrangement according to claim 6, in which the base corner piece (1) further has an inlay (7), in particular a plastic inlay, which extends in the interior space (6) between the cover side (4) and the bottom side (5) and which at its end in front of the cover side (4) has a receptacle (8) which is open towards the cover side (4), in which receptacle a threaded nut (9) is accommodated in a rotation-proof manner

8. The arrangement according to claim 7, in which the inlay (7) is releasably connected to the shaped part (2) in a mounting position in the interior space (6), in particular latched.

9. The arrangement according to claim 7 or 8, in which a threaded passage (10) of the threaded nut (9) is aligned with an opening (11) through the cover side (4) and accessible via the opening (11).

10. The arrangement according to any of claims 7 to 9, in which the cover side (4) has a trough-shaped recess (12) for the positive reception of a sliding skid (13), wherein an opening (11) through the cover side (4) is arranged in the recess (12), which is aligned with a threaded passage (10) of the threaded nut (9).

11. The arrangement according to any of claims 6 to 10, in which the outer walls (3) each have a first U-edging (14) at their free longitudinal edge, with a first profile side (15) extending perpendicularly to the outer wall (3) and a second profile side (16) formed on the first profile side (15), which extends parallel to the outer wall (3) and has a free edge (7) arranged in the interior space (6).

12. The arrangement according to claim 11, in which the first U-edgings (14) comprises the second mounting side on at least one of the first and second profile side (15, 16).

13. The arrangement according to claim 11, in which the inlay (7) has a first and a second pair of guide pins (19) spaced apart, the first pair of guide pins (19) with its free ends abutting the second profile side (16) of a first one of the two U-edgings (14), and wherein the second pair of guide pins (19) with its free ends abutting the second profile side (16) of a second of the U-edgings (14).

14. The arrangement according to claim 13, in which the inlay (7) also has a first and a second fastening means (20), in particular a first and a second pair of latching pawls pre-tensionable against each other, and which extends with its free end between one of the pairs of guide pins (19) each towards and parallel to the respective second profile side (16)

15. The arrangement according to any of claims 11 to 14, in which a base panel (300) can engage around one of the two U-edgings (14) with a fastening tab (301), wherein a free end (302) of the fastening tab (301) extends perpendicularly to the panel front (303), abuts against the second profile side (16) of one of the first U-edgings (14) and is preferably fixed to the second profile side (16).

16. The arrangement according to claim 15, in which the free end (302) of the fastening tab (301) has an undercut clearance (305) on an edge (304) facing the interior space (6), in which undercut clearance a fastening means (20) of the inlay (7), in particular a pair of latching pawls, engages

17. The arrangement according to any of claims 11 to 16, in which the interior space (6) of the base corner piece (1) is closed off by a corner panel (21) which abuts parallel to the first profile sides (15) of the first U-edgings (14) and engages one of the two free edges (17) of each of the two second profile sides (16) with a latching hook (22).

18. The arrangement according to any of claims 11 to 17, in which the two first profile sides (15) of the first U-edgings (14) and the two second profile sides (16) of the first U-edgings (14) are aligned perpendicular to each other.

19. The arrangement according to claim 5, in which the outer walls (3) are connected to each other via a connecting side (23) of the shaped part (2), wherein the connecting side (23) has a polygonal aperture (24) into which the inlay (7) engages with a positive locking adapter (26) formed on its rear side (25) and facing the connecting side (23).

20. The arrangement according to claim 6, in which a threaded bolt (27) extends between the cover side (4) and the bottom side (5) as well as through the cover side (4), with a levelling sleeve (28) screwed onto the threaded bolt (27) and arranged between the cover side (4) and the bottom side (5) and on which a levelling base (30) is formed which extends through the bottom side (5).

21. The arrangement according to claim 6, in which on the shaped part (2), a transport roller (37) is fixed which can be swivelled between a transport position and a storage position, wherein, in the storage position, a support plane of the transport roller (37) lies in or above a support plane of the base corner piece (1) and wherein, in the transport position, the support plane of the transport roller (37) lies below the support plane of the base corner piece (1).

22. The arrangement according to any of the preceding claims, in which a base panel (300) of the switch cabinet base (100) has a second U-edging (38) on opposite longitudinal edges each, wherein the second U-edgings (38) have a free mounting side (39) each which can be arranged on a rear side of the base panel (300) parallel to a front side of the base panel (300) and in a common plane, wherein the free mounting sides (39) each have a row of holes of further mounting receptacles (40), and wherein the rows of holes run parallel to each other and have a distance to each other that corresponds to an integer multiple of the grid dimension (x).

23. The arrangement according to claim 22, in which the switch cabinet base has two of the base panels (300) which are arranged opposite each other with their second U-edgings (38) facing each other, wherein a bottom sheet (500) is fixed to and extending between the two base panels (300) via a pair of opposing free mounting sides (39) of the second U-edgings (38) of the two base panels (300), wherein preferably a support and a fastening plane for the bottom sheet (500) are provided via a fastening bracket (600) fixed to the base panels (300).

24. The arrangement according to any of the preceding claims, in which a base panel (300) of the switch cabinet base is an anti-tilt protection for the assembly by mounting the base panel (300) between adjacent base corner pieces (1) in a horizontal orientation, in which the base panel (300) rests with its front or rear side on a support on which the assembly rests and with a longitudinal edge projects beyond the clear outer dimension of the frame rack (200) and any flat parts optionally mounted thereon.

25. A switch cabinet row consisting of at least two of the arrangements according to any of the preceding claims, in which two pairs of facing base corner pieces (1) of adjacent switch cabinet bases (100), arranged at a distance from each other in the depth direction of the switch cabinet row, are connected to each other via a first base panel (300) running in depth direction.

26. The switch cabinet row according to claim 25, in which the first base panel (300) is aligned horizontally and its front faces the support on which the switch cabinet row stands.

27. The switch cabinet row according to any of claims 25 or 26, in which the switch cabinet row has a second base panel (300) identical to the first base panel (300), which is vertically aligned and extends between two base corner pieces (1) of the same switch cabinet base (100).

28. The switch cabinet row according to any of claims 25 to 27, in which the first base panel (300) has a second U-edging (38) each along its two longitudinal edges with a free mounting side (39) each, which runs parallel to the front side at a distance from a front side of the base panel (300) at a rear side of the base panel (300) and has a row of holes of further mounting receptacles (40) in its direction of extension, wherein the rows of holes run parallel to each other and have a distance to each other that corresponds to an integer multiple of the grid dimension (x).

29. The switch cabinet row according to claim 27, in which the first and second base panels (300) are identically formed and have a second U-edging (38) each along their two longitudinal edges, wherein in each case a mounting flange (41) is formed on the second U-edgings which extends perpendicularly to all three profile sides of the second U-edging (38).

30. The switch cabinet row according to claim 29, in which one of the switch cabinet bases (100) has a first base panel (300) on opposite sides each, the base panels (300) each having a row of system perforations(18) on mutually facing longitudinal edges which run parallel to one another and are spaced apart by a distance corresponding to an integral multiple of the grid dimension (x), and wherein an interior installation component (400), such as a cable catch rail or a mounting chassis, extends between the longitudinal edges and is fixed to the rows of system perforations (18) with opposing fastening sections (401).

## Revendications

1. Disposition constituée d'un socle d'armoire de commande (100) et d'un châssis d'armoire de commande (200) monté dessus, dans laquelle le socle d'armoire de commande (100) comprend plusieurs pièces angulaires de socle (1), qui sont fixées au châssis d'armoire de commande (200) et le châssis d'armoire de commande (200) comprend une pluralité de montants profilés (201), parmi lesquels au moins un montant profilé (201) comprend une première face de montage (202, 204, 205, 208) avec une série de trous, constituée de premiers logements de fixation (203, 206, 207, 209) et dans laquelle au moins une des pièces angulaires de socle (1) comprend une deuxième face de montage (3, 15, 16, 23) avec une série de trous, constituée de deuxièmes logements de fixation (18), **caractérisée en ce que** les deuxièmes logements de fixation (18) sont distants entre eux de la même dimension modulaire (x) que les premiers logements de fixation (203, 206, 207, 209).

2. Disposition selon la revendication 1, dans laquelle au moins une des conditions suivantes est remplie :
a. les première et deuxième faces de montage (3, 15, 16, 23, 202) sont disposées dans le même plan ;
b. les deux séries de trous sont distantes entre elles de la dimension modulaire (x) ou d'un multiple entier de la dimension modulaire (x).

3. Disposition selon l'une des revendications 1 ou 2, qui comprend en outre un composant de garniture intérieure (400) qui
a. est fixé avec une première portion de fixation (401) dans un volume entouré par le châssis d'armoire de commande (200) et avec une deuxième portion de fixation (402) dans un volume entouré par le socle d'armoire de commande (100) ou
b. est fixé avec une première portion de fixation (401), par l'intermédiaire d'un des premiers logements de fixation (203, 206, 207, 209), à la première face de montage (202, 204, 208) du montant profilé (201) et qui est fixé avec une deuxième portion de fixation (402), par l'intermédiaire d'un des deuxièmes logements de fixation (18), à la deuxième face de montage (3, 15, 16, 23) de la pièce angulaire de socle (1) ou
c. est fixé avec une première portion de fixation (401), par l'intermédiaire d'un des deuxièmes logements de fixation (18), à la deuxième face de montage (3, 15, 16, 23) de la pièce angulaire de socle (1) et qui est fixé avec une deuxième portion de fixation (402), par l'intermédiaire d'un des deuxièmes logements de fixation (18), à la deuxième face de montage (3, 15, 16, 23) d'une autre des pièces angulaires de socle (1), dans laquelle les deux séries de trous des deuxièmes logements de fixation (18) des pièces angulaires de socle (1) présentent une distance entre elles qui correspond à un multiple entier de la dimension modulaire (x).

4. Disposition selon la revendication 3, dans laquelle la première portion de fixation (401) du composant de garniture intérieure (400) comprend un premier moyen de fixation (403) et la deuxième portion de fixation (402) du composant de garniture intérieure (400) comprend un deuxième moyen de fixation (403), dans laquelle les moyens de fixation (403) présentent entre eux une distance qui correspond à un multiple entier de la dimension modulaire (x).

5. Disposition selon l'une des revendications précédentes, dans laquelle deux des pièces angulaires de socle (1) du socle d'armoire de commande (100) sont disposées de manière orientée l'une vers l'autre, avec chacune une paroi externe (3), dans laquelle les parois externes (3) comprennent chacune la deuxième face de montage (3, 15, 16, 23) comprenant les deuxièmes logements de fixation (18) et dans laquelle les parois externes (3) sont disposées à une distance entre elles qui correspond à un multiple entier de la dimension modulaire (x).

6. Disposition selon l'une des revendications précédentes, dans laquelle la pièce angulaire de socle (1) comprend une pièce moulée (2), plus particulièrement une pièce moulée en tôle, qui comprend une première et une deuxième parois externes (3), qui s'étendent perpendiculairement entre elles, et qui comprend en outre une face de recouvrement supérieure (4) et une face de fond inférieure (5) qui sont disposées de manière parallèle entre elles et perpendiculaire aux parois externes (3), dans laquelle les parois externes (3), la face de recouvrement (4) et la face de fond (5) délimitent un espace interne (6) de la pièce angulaire de socle (1) qui est ouvert en direction d'un angle de la pièce moulée (2).

7. Disposition selon la revendication 6, dans laquelle la pièce angulaire de socle (1) comprend en outre une incrustation (7), plus particulièrement une incrustation en matière plastique, qui s'étend dans l'espace interne (6) entre la face de recouvrement (4) et la face de fond (5) et qui comprend, au niveau de son extrémité en amont de la face de recouvrement (4), un logement (8) ouvert en direction de la face de recouvrement (4), dans lequel est logé, sans possibilité de rotation, un écrou fileté (9).

8. Disposition selon la revendication 7, dans laquelle l'incrustation (7) est reliée, de manière amovible, plus particulièrement encliquetée, dans une position de montage dans l'espace interne (6) avec la pièce moulée (2).

9. Disposition selon la revendication 7 ou 8, dans laquelle un passage fileté (10) de l'écrou fileté (9) est aligné avec une percée (11) à travers la face de recouvrement (4) et est accessible par l'intermédiaire de celui-ci.

10. Disposition selon l'une des revendications 7 à 9, dans laquelle la face de recouvrement (4) comprend une cavité en forme d'auge (12) pour le logement par complémentarité de forme d'un patin de glissement (13), dans laquelle, dans la cavité (12), est réalisée une percée (11) à travers la face de recouvrement (4) qui est alignée avec un passage fileté (10) de l'écrou fileté (9).

11. Disposition selon l'une des revendications 6 à 10, dans laquelle les parois externes (3) présentent chacune, au niveau de leur arête longitudinale libre, un premier pliage en U (14) avec une première face profilée (15) s'étendant perpendiculairement à la paroi externe (3) et une deuxième face profilée (16) formée au niveau de la première face profilée (15), qui s'étend parallèlement à la paroi externe (3) et qui présente une arête libre (17) disposée dans l'espace interne (6).

12. Disposition selon la revendication 11, dans laquelle les premiers pliages en U (14) comprennent la deuxième face de montage au moins au niveau des première et deuxième faces profilées (15, 16).

13. Disposition selon la revendication 11, dans laquelle l'incrustation (7) comprend une première et une deuxième paires de tiges de guidage (19) distantes entre elles, dans laquelle la première paire de tiges de guidage (19) s'appuie, avec son extrémité libre, contre la deuxième face profilée (16) d'un premier des deux premiers pliages en U (14) et dans laquelle la deuxième paire de tiges de guidage (19) s'appuie, avec son extrémité libre, contre la deuxième face profilée (16) d'un deuxième des deux premiers pliages en U (14).

14. Disposition selon la revendication 13, dans laquelle l'incrustation (7) comprend en outre un premier et un deuxième moyens de fixation (20), plus particulièrement une première et une deuxième paires de cliquets pouvant être précontraints l'une par rapport à l'autre, qui s'étendent, avec leur extrémité libre, chacun entre une des paires de tiges de guidage (19) en direction de la deuxième face profilée (16) respective et parallèlement à celle-ci.

15. Disposition selon l'une des revendications 11 à 14, dans laquelle un panneau de socle (300) entoure, avec une patte de fixation (301), un des deux pliages en U (14), dans laquelle une extrémité libre (302) de la patte de fixation (301) s'étend perpendiculairement à la face avant du panneau (303), s'appuie contre la deuxième face profilée (16) d'un des premiers pliages en U (14) et est de préférence fixée à la deuxième face profilée (16).

16. Disposition selon la revendication 15, dans laquelle l'extrémité libre (302) de la patte de fixation (301) comprend, au niveau d'une arête (304) orientée vers l'espace interne (6), un évidement à contre-dépouille (305) dans lequel un moyen de fixation (20) de l'incrustation (7), plus particulièrement une paire de cliquets, s'emboîte.

17. Disposition selon l'une des revendications 11 à 16, dans laquelle l'espace interne (6) de la pièce angulaire de socle (1) est fermé par un panneau angulaire (21) qui s'appuie parallèlement contre les premières faces profilées (15) des premiers pliages en U (14) et s'emboîte respectivement avec un crochet d'encliquetage (22) au niveau d'une des deux arêtes libres (17) des deux deuxièmes faces profilées (16).

18. Disposition selon l'une des revendications 11 à 17, dans laquelle les deux premières faces profilées (15) des premiers pliages en U (14) et les deuxièmes faces profilées (16) des premiers pliages en U (14) sont perpendiculaires entre elles.

19. Disposition selon la revendication 5, dans laquelle les parois externes (3) sont reliées entre elles par l'intermédiaire d'une face de raccordement (23) de la pièce moulée (2), dans laquelle la face de raccordement (23) comprend un passage polygonal (24) dans lequel l'incrustation (7) s'emboîte avec un adaptateur de complémentarité de forme (26) réalisé au niveau de sa face arrière (25) et orienté vers la face de raccordement (23).

20. Disposition selon la revendication 6, dans laquelle une tige filetée (27) s'étend entre la face de recouvrement (4) et la face de fond (5) ainsi qu'à travers la face de recouvrement (4), avec une douille de nivellement (28) qui est vissée sur la tige filetée (27) et qui est disposée entre la face de recouvrement (4) et la face de fond (5) et au niveau de laquelle est formé un socle de nivellement (30) qui s'étend à travers la face de fond (5).

21. Disposition selon la revendication 6, dans laquelle, à la pièce moulée (2), est fixée un rouleau de transport (37) qui peut être pivoté entre une position de transport et une position de stockage, dans laquelle, dans la position de stockage, un plan d'appui du rouleau de transport (37) se trouve dans un plan d'appui de la pièce angulaire de socle (1) ou au-dessus, et dans laquelle, dans la position de transport, le plan d'appui du rouleau de transport (37) se trouve en dessous du plan d'appui de la pièce angulaire de socle (1).

22. Disposition selon l'une des revendications précédentes, dans laquelle un panneau de socle (300) du socle d'armoire de commande (100) comprend, au niveau d'arêtes longitudinales opposées respectives, un deuxième pliage en U (38), dans laquelle les deuxièmes pliages en U (38) comprennent chacun une face de montage libre (39) qui est disposée au niveau d'une face arrière du panneau de socle (300) distante de manière parallèle par rapport à une face avant du panneau de socle (300) et dans un plan commun, dans laquelle les faces de montage libres (39) comprennent chacune une série de trous constituée de logements de fixation supplémentaires (40) et dans laquelle les séries de trous sont parallèles entre elles et présentent entre elles une distance qui correspond à un multiple entier de la dimension modulaire (x).

23. Disposition selon la revendication 22, dans laquelle le socle d'armoire de commande comprend deux des panneaux de socle (300) qui sont disposés en face l'un de l'autre avec leurs deuxièmes pliages en U (38) orientés l'un vers l'autre, dans laquelle une paire de faces de montage libres (39) opposées des deuxièmes pliages en U (38) des deux panneaux de socle (300) permet de fixer une tôle de fond (500) aux deux panneaux de socle (300) de façon à ce qu'elle s'étende entre ceux-ci, dans laquelle, de préférence, un angle de fixation (600) fixé aux panneaux de socle (300) permet de mettre à disposition un appui et un plan de fixation pour la tôle de fond (500).

24. Disposition selon l'une des revendications précédentes, dans laquelle un panneau de socle (300) du socle d'armoire de commande constitue une protection anti-basculement pour la disposition, grâce au fait que le panneau de socle (300) est monté entre des pièces angulaires de socle (1) adjacentes dans une orientation horizontale, dans laquelle le panneau de socle (300) s'appuie, sa face avant ou sa face arrière, sur u support sur lequel est posé la disposition, et dépasse, avec une arête longitudinale, de la dimension extérieure hors tout du châssis (200) ainsi que des pièces plates éventuellement montées sur celui-ci.

25. Série d'armoires de commande constituée d'au moins deux des dispositions selon l'une des revendications précédentes, dans laquelle deux paires, disposées de manière distante entre elles, dans la direction de la profondeur de la série d'armoires de commande, de pièces angulaires de socle (1), orientées l'une vers l'autre, de socles d'armoire de commande (100) adjacents, sont reliées entre elles par l'intermédiaire d'un premier panneau de socle (300) s'étendant dans la direction de la profondeur.

26. Série d'armoires de commande selon la revendication 25, dans laquelle le premier panneau de socle (300) est orienté horizontalement et sa face avant est orienté vers le support sur lequel est posée la série d'armoires de commande.

27. Série d'armoires de commande selon la revendication 25 ou 26, dans laquelle la série d'armoires de commande comprend un deuxième panneau de socle (300) identique au premier panneau de socle (300), qui est orienté verticalement et qui s'étend entre deux pièces angulaires de socle (1) de ce socle d'armoire de commande (100).

28. Série d'armoires de commande selon l'une des revendications 25 à 27, dans laquelle le premier panneau de socle (300) comprend, le long de ses deux arêtes longitudinales, respectivement un deuxième pliage en U (38) avec une face de montage libre (39), qui s'étend au niveau d'une face arrière du panneau de socle (300) à une distance d'une face avant du panneau de socle (300), parallèlement à la face avant et comprend une série de trous s'étendant dans sa direction d'extension, constituée de logements de fixation supplémentaires (40), dans laquelle les séries de trous s'étendent parallèlement entre elles et présentent entre elles une distance qui correspond à un multiple entier de la dimension modulaire (x).

29. Série d'armoires de commande selon la revendication 27, dans laquelle les premier et deuxième panneaux de socle (300) sont identiques et comprennent, le long de leurs deux arêtes longitudinales, respectivement un deuxième pliage en U (38), dans laquelle une bride de fixation (41) est formée respectivement au niveau des deuxièmes pliages en U, qui s'étend perpendiculairement aux trois faces profilées du deuxième pliage en U (38).

30. Série d'armoires de commande selon la revendication 26, dans laquelle un des socles d'armoire de commande (100) comprend, au niveau de faces opposées, respectivement un premier panneau de socle (300) dans laquelle les panneaux de socle (300) comprennent, au niveau d'arêtes longitudinales (38) orientées les unes vers les autres, chacune une série de trous de système (18) qui s'étendent parallèlement entre elles et qui présentent entre elles une distance qui correspond à un multiple entier de la dimension modulaire (x) et dans laquelle un composant de garniture intérieure (400), par exemple un rail porte-câble ou un châssis de montage, s'étend entre les arêtes longitudinales et est fixé avec des portions de fixation (401) opposées aux séries de trous de système (18).
